(19) **Europäisches Patentamt**

**European Patent Office**

**Office européen des brevets**

(11) **EP 1 624 314 A1**

(12) **EUROPÄISCHE PATENTANMELDUNG**

(43) Veröffentlichungstag:
**08.02.2006 Patentblatt 2006/06**

(51) Int Cl.:
*G01R 33/34* *(2006.01)*    *G01R 33/345* *(2006.01)*

(21) Anmeldenummer: **04018597.7**

(22) Anmeldetag: **05.08.2004**

(84) Benannte Vertragsstaaten:
**AT BE BG CH CY CZ DE DK EE ES FI FR GB GR HU IE IT LI LU MC NL PL PT RO SE SI SK TR**
Benannte Erstreckungsstaaten:
**AL HR LT LV MK**

(71) Anmelder: **Max-Planck-Gesellschaft zur Förderung**
**der Wissenschaften e.V.**
**80539 München (DE)**

(72) Erfinder:
- **Driesel, Wolfgang, Dr.**
  **06792 Sandersdorf (DE)**
- **Mildner, Toralf, Dr.**
  **04157 Leipzig (DE)**
- **Möller, Harald, Dr.**
  **04107 Leipzig (DE)**

(74) Vertreter: **König, Beate**
**König & Köster,**
**Morassistrasse 8**
**80469 München (DE)**

(54) **Helmförmige TEM-Antenne für Magnetresonanzmessungen**

(57) Gegenstand der Erfindung ist ein HF-Antennensystem zum Anregen und/oder Erfassen der Magnetresonanz in einem zu untersuchenden Objekt, das einem magnetischen Hauptfeld ausgesetzt ist, welches die Spins des Objektes in einer gewünschten Longitudinalrichtung (z) ausrichtet, mit mindestens einem ersten Antennengebilde (1), enthaltend mehrere Leitungsabschnitte (11, 12, 13, 14), die jeweils zum Leiten hochfrequenten Wechselstroms ausgelegt sind und die sich von einem gemeinsamen Scheitelbereich krallenförmig auseinanderstrebend bis zu einem Basisbereich erstrecken, um einen das interessierende Volumen enthaltenden Teil des Untersuchungsobjektes helmartig zu umgreifen. Die Erfindung ist dadurch gekennzeichnet, dass jeder Leitungsabschnitt (11, 12, 13, 14) als HF-Leitung (HL) ausgebildet ist zum Führen einer sich im TEM-Modus oder in einem Quasi-TEM-Modus ausbreitenden Leitungswelle in elektromagnetischer Kopplung mit Spins des zu umgreifenden Untersuchungsobjektes, und dass die elektrische Länge und die Terminierungen der HF-Leitungen (HL) so gewählt sind, dass sich bei der Frequenz der Magnetresonanz stehende Wellen in den HF-Leitungen ergeben.

Fig. 4

EP 1 624 314 A1

**Beschreibung**

Die Erfindung betrifft ein HF-Antennensystem zum Anregen und/oder Erfassen von Magnetresonanz in einem interessierenden Messvolumen eines zu untersuchenden Objektes, das einem magnetischen Hauptfeld ausgesetzt ist, welches die Spins des Objektes in einer gewünschten Longitudinalrichtung ausrichtet, mit Merkmalen gemäß dem Oberbegriff des Patentanspruchs 1. Hauptsächliche Anwendungsgebiete der Erfindung sind die Magnetresonanz-Bildgebung (magnetic resonance imaging, MRI) und die Magnetresonanz-Spektroskopie (MRS).

In der nachstehenden Beschreibung werden bei der Angabe und Würdigung des Standes der Technik entsprechende Fundstellen in der allgemein zugänglichen Literatur genannt:

[1] R. Bader et al., "A wide frequency range antenna system for multinuclear MRS and MRI.", SMRM, 6th Annual Meeting, New York 1987, S. 406;

[2] P. K. Röschmann, "Surface coil for high-frequency magnetic fields for magnetic resonance examinations.", US Pat. Nr. 4.775.837;

[3] J. T. Vaughan et al., "High frequency surface coils for clinical NMR imaging and spectroscopy.", SMRM 12th Ann. Meeting, New York 1993, S. 1332;

[4] C.E. Hayes et al., "An efficient, highly homogeneous radiofrequency coil for whole-body NMR-imaging at 1,5-T." J. Magn. Reson. 1985, 63: 622-628;

[5] W. A. Edelstein et al., "The relative sensitivity of surface coils to deep lying tissues." SMRM, 4th Annual Meeting, San Francisco 1985, S. 964-965;

[6] Silva u. Merkle, "Hardware considerations for functional magnetic resonance imaging." Concepts Magn. Reson. A, 2003; 16: 35-49;

[7] T. Mildner et al., "Functional perfusion imaging using continuous arterial spin labeling with separate labeling and imaging coils at 3 T." Magn. Reson. Med. 2003, 49: 791-795;

[8] J. T. Vaughan et al., "High frequency volume coils for clinical NMR imaging and spectroscopy.", Magn. Reson. Med. 1994, 32: 206-218;

[9] J. T. Vaughan, "Radio frequency volume coil.", US Pat. Nr. 5.557.247, 1996;

[10] J. T. Vaughan, "HF-coil for imaging system and use therein.", US Pat. 60/135269;

[11] G. Bogdanov u. R. Ludwig, "Coupled microstrip line transverse electromagnetic resonator modul for high-field magnetic resonance.", Magn. Reson. Med. 2002, 47: 579-593;

[12] P. Bottomley, "MRI tunable antenna and system.", WO 03/0582283;

[13] R.F. Lee et al., "Lumped-element planar strip array (LPSA).", Magn. Reson. Med. 2004, 51: 172-183;

[14] R.F. Lee et al., "Planar strip array (PSA) for MRI." Magn. Reson. Med. 2001; 45: 673-683;

[15] W. Driesel u. H. Merkle, "3-Tesla-helmet coil customization to allow for more general fMRI studies." MAGMA 2003, 16(Suppl. 7): 163;

[16] X. Zhang et al., "Microstrip RF surface coil design for extremely high-field MRI and spectroscopy." Magn. Res. Med. 2001; 46: 443-450;

[17] J. D. Jackson, "Klassische Elektrodynamik." W. de Gruyter, Berlin 1983;

[18] I. J. Bahl u. D. K. Trivedl, "A designer's guide to micostrip line." Microwaves, May 1977, S. 174-179;

[19] F. Schnieder u. W. Heinrich, "Model of thin-film microstrip line for circuit design." IEEE Trans. Microwave Theory Tech. 2001, 49: 104-110;

[20] T. Itoh, "Overview of quasi-planar transmission lines." IEEE Trans. Microwave Theory Tech. 1989, 37: 275-280;

[21] G. Zaharchuk et al., "Multislice perfusion and perfusion territory imaging in humans with separate label and image coils." Magn. Reson. Med. 1999; 41: 1093-1098;

[22] R. Trampel et al., "Continuous arterial spin labeling using a local magnetic field gradient coil." Magn. Reson. Med. 2002; 48: 543-546.

[23] M. D.Schnall, "Probes tuned to multiple frequencies for in-vivo NMR." In: NMR Basic Principles and Progress, 26: 33-63, Springer, Heidelberg, 1992.

Diese Fundstellen sind im Beschreibungstext durch Angabe der vorstehenden Referenznummern in eckigen Klammern [] bezeichnet.

Da die Anordnungen zum Anregen und/oder Erfassen von Magnetresonanz in den Anfängen der Magnetresonanztechnik die Gestalt von spulenähnlich gewundenen Leiterschleifen hatten, werden sie heute oft noch als "Spulen" (engl.: "coils") bezeichnet, auch dann, wenn ihre tatsächliche Ausbildung keine Ähnlichkeit mit dem hat, was man allgemein unter einer Spule versteht. Im hier vorgelegten Text wird die umfassendere Bezeichnung "Antenne" bevorzugt, die mittlerweile auch in Teilen der Fachliteratur gebräuchlich geworden ist.

Von besonderem Interesse bezüglich des Designs der HF-Antenne ist das HF-Feld im Nahbereich, d.h. Bereiche des Untersuchungsobjekts in der unmittelbaren Umgebung der Antenne (Abstände von bis zu einer Wellenlänge). Das so genannte Fernfeld will man möglichst vermeiden, da es lediglich zu unerwünschten Wechselwirkungen mit der Umgebung führt. Im medizinischen Bereich, z.B. bei der Untersuchung des menschlichen Gehirns, findet man ein breites Spektrum für die Anwendung derartiger Antennen. Die Erfindung ist aber auch in andern Bereichen der MRI und MRS und bei anderen Objekten vorteilhaft nutzbar.

Bei der MRI bzw. MRS bringt man das zu untersuchende Objekt in ein starkes statisches Magnetfeld ($B_0$-Feld) ein. Enthält das Untersuchungsobjekt Atomkerne mit einem von Null verschiedenen Kernpin, richten sich die Spins bzw. die mit ihnen verknüpften magnetischen Kernmomente im $B_0$-Feld aus, und es kommt zur Aufspaltung der im feldfreien Raum entarteten Kernspin-Energieniveaus. Die Kernmomente führen eine Präzessionsbewegung um die Richtung des statischen Magnetfeldes $B_0$ aus. Die Frequenz der Präzession (Larmorfrequenz w) ist proportional zur $B_0$-Feldstärke:

$$\omega = \gamma * B_0 .$$

Das Symbol "*" bezeichnet hier und im Folgenden den Operator für Multiplikation. Der Proportionalitätsfaktor y ist das gyromagnetische Verhältnis des untersuchten Atomkerns. Die Larmorfrequenz liegt je nach $B_0$-Feldstärke im Bereich von ca. 1 MHz bis 1 GHz. Als auf das Volumen normierte Vektorsumme der magnetischen Kernmomente im Untersuchungsobjekt ergibt sich eine makroskopische Magnetisierung, die im thermischen Gleichgewicht parallel zur Richtung des statischen Felds $B_0$ weist. Zum Auslenken der Magnetisierung, also zur Erzeugung eines messbaren Magnetresonanzsignals, wird elektromagnetische HF-Leistung mit der Larmorfrequenz $\omega$ mittels eines HF-Senders und einer HF-Antenne pulsförmig oder auch kontinuierlich in das Untersuchungsobjekt eingestrahlt. Im Empfangsfall misst man die in der Antenne induzierte Spannung als Antwortsignal der angeregten Spins. Durch Auswertung dieses "Magnetresonanzsignals" lassen sich Rückschlüsse auf die physikalische und chemische Struktur des Objekts ziehen. Bei biomedizinischen Anwendungen sind auf diese Weise morphologische, metabolische und funktionelle Untersuchungen möglich. Überlagert man dem homogenen $B_0$-Feld einen $B_0$-Feldgradienten, so wird die Larmorfrequenz ortsabhängig. Diese Eigenschaft wird bei der MRI zur Ortscodierung genutzt.

Die gewünschte Wechselwirkung zwischen den Spins des Untersuchungsobjektes und der HF-Antenne ergibt sich nur für solche Orte des Untersuchungsobjektes, wo das magnetische Wechselfeld eine Komponente orthogonal zur z-Richtung hat, also orthogonal zur Richtung des $B_0$-Feldes. Diese Komponente wird als "$B_1$-Feld" bezeichnet.

Die gebräuchlichen Sende/Empfangsantennen für Magnetresonanz lassen sich grob unterteilen in Oberflächen- und Volumenantennen. Zu den Oberflächenantennen zählen, neben einfachen Leiterschleifen, u.a. auch schleifenartige Gebilde aus Wellenleitern, siehe [1], [2], und [3].

Typische Vertreter von Volumenantennen sind u. a. Sattelspulen, Solenoide, und Birdcage-Resonatoren. Auch Kombinationen von Oberflächenantennen und Volumenantennen sind bekannt. Volumenantennen, die ein sehr homogenes HF-Feld ($B_1$-Feld) erzeugen, sind insbesondere die Birdcage-Resonatoren, siehe [4].

Alle diese Antennentypen weisen in der Anwendung Nachteile auf. So ist mit einer Volumenantenne zwar eine sehr homogene Ausleuchtung des Objekts erreichbar, jedoch wird eine geringere Empfindlichkeit bezüglich des Magnetresonanzsignals erzielt. Oberflächenantennen haben demgegenüber in oberflächennahen Bereichen, d. h. in geringer Tiefe senkrecht zur Antennenebene, eine sehr hohe Empfindlichkeit gegenüber dem Magnetresonanzsignal, siehe [5]. Die Ausleuchtung erfolgt aber sehr inhomogen und nimmt mit zunehmender Entfernung rasch ab. Oberflächenantennen sind etwa bis zu einer Tiefe, die dem Durchmesser der Antenne entspricht, vorteilhaft für den Empfang des Magnetresonanzsignals einsetzbar.

Allen Bemühungen um ein optimales Antennendesign liegt der Wunsch zugrunde, eine HF-Antenne zu schaffen, die möglichst nur im interessierenden Bereich (also im "Messvolumen") empfindlich ist, d. h. nur dort die Kerne im Untersuchungsobjekt anregt und nur von dort Magnetresonanzsignale empfängt. Ideal wäre es, wenn in diesem Bereich die Ausleuchtung möglichst homogen ist und die Antenne eine hohe Empfindlichkeit für das eigentliche Messvolumen besitzt. Diese beiden Forderungen schließen sich gegenseitig aus. Bekanntlich ist in unmittelbarer Nähe von Leitern das Magnetfeld sehr inhomogen, die Empfangseffizienz S bezüglich des Magnetresonanzsignals aber hoch:

$$S \sim B(r)/I ,$$

wobei B(r) das Magnetfeld in der Entfernung r vom Leiter und I den Strom durch den Leiter bezeichnen. Das Symbol "~" bedeutet "proportional zu", und das Symbol "/" bezeichnet hier den Operator für Division. Umgekehrte Verhältnisse findet man in größerer Entfernung zu den Leitern.

Dies ist ein Problem, wenn verschiedene Orte im Messvolumen unterschiedliche Entfernung zur Antenne haben. Das Design von HF-Antennen stellt also immer einen Kompromiss zwischen den beiden konkurrierenden Gesichtspunkten dar. Daraus wird ersichtlich, dass HF-Antennen für entsprechende Anwendungen optimiert werden müssen.

Eine bekannte Maßnahme hierzu ist, die Antenne in ihrer Form an das zu untersuchende Objekt derart anzupassen, dass der interessierende Volumenbereich des Objektes vom Magnetfeld im Nahbereich möglichst gut erfasst wird. So wurden für die Untersuchung des menschlichen Gehirns anatomisch angepasste Antennen entwickelt, die einen menschlichen Kopf helmartig umschließen können, siehe [6]. Eine solche "Helmantenne" hat in ihrer bekannten Ausführungsform jedoch gewisse Nachteile, wie nachstehend anhand einer Figur der beigefügten Zeichnungen erläutert wird:

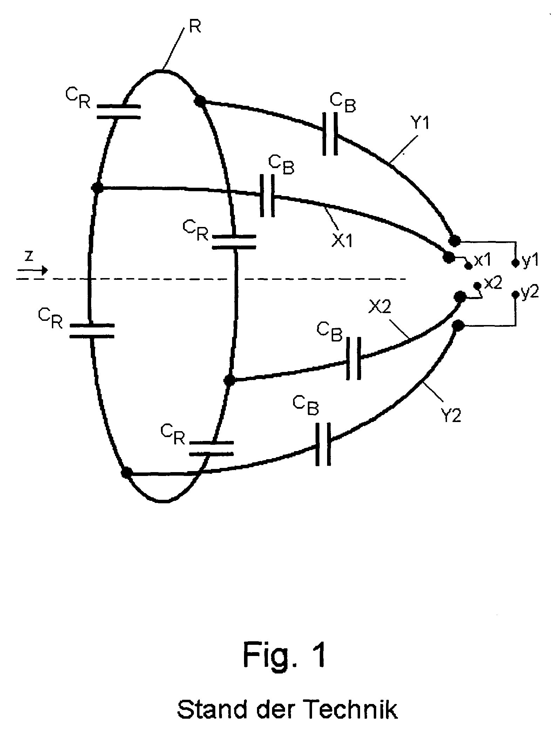

Fig. 1    zeigt schematisch den Aufbau einer Helmantenne nach dem Stand der Technik.

Die Antenne nach Fig. 1 enthält, in ihrer gezeigten einfachsten Form, eine ringförmige leitende Basis R, die durch vier gleichmäßig auf dem Umfang verteilte Kondensatoren $C_R$ in vier Bereiche unterteilt ist. Auf halbem Weg zwischen jeweils zwei benachbarten Ringkondensatoren $C_R$ mündet einer von vier um 90° versetzen leitenden Bügeln X1, X2, Y1, Y2 ein, die ihrerseits zu Anstimmzwecken und zur Vermeidung von Phasenverschiebungen ebenfalls mittels Kondensatoren $C_B$ unterteilt sind. Die beiden diametral gegenüberliegenden Bügel X1 und X2 sind am anderen Ende mit einem ersten Speiseanschluss x1-x2 verbunden. Die anderen beiden diametral gegenüberliegenden Bügelhälften Y1 und Y2 sind mit einem zweiten Speiseanschluss y1-y2 verbunden. Jedes Paar zweier diametral gegenüberliegender Bügel bildet einen sich über den Basisring R schließenden Stromkreis.

Der Basisring R, das erste Bügelpaar X1, X2 und das zweite Bügelpaar Y1, Y2 wirken als drei Teilantennen. Da diese drei Teilantennen in drei zueinander senkrechten Ebenen angeordnet sind, kann man, bei exakt symmetrischem Aufbau der Helmantenne bezüglich der z-Achse, eine Entkopplung zwischen den drei Teilantennen erreichen. Nur die beiden X- und Y-Bügelpaare erzeugen im Wesentlichen ein Magnetfeld senkrecht zur z-Achse, also ein wirksames $B_1$-Feld, und sind somit aktiv bezüglich der Magnetresonanz. Weiterhin ergibt sich bei der beschriebenen Helmantenne ein starker Gradient des $B_1$-Feldes, gemessen in $B_0$-Richtung (z-Richtung), denn wegen der geometrischen Form der Bügelpaare ist dieses Feld im Bereich der Basis der Antenne, wo die Bügel weiter auseinander liegen, viel schwächer als im Bereich des Scheitels der Antenne. Dies führt dazu, dass nur im oberen Bereich des Gehirns Untersuchungen mit brauchbarem Signal-zu-Rausch-Verhältnis (signalto-noise ratio, SNR) möglich sind.

Neben diesem Nachteil gibt es noch ein weiteres Problem, das im beschriebenen Helmantennen-Konzept begründet ist. Wie oben ausgeführt, nutzen diese Antennenkonzepte eine ringförmige Basis für den Stromfluss zwischen den beiden scheitelfernen Enden jedes Bügelpaares. Dies führt zu einem schwerwiegenden Nachteil, der für ein Bügelpaar erläutert werden soll. Die Ausführungen treffen sinngemäß auch für das um 90° versetzte Bügelpaar zu. Der aus einem Bügel in die ringförmige Basis dringende Strom fließt je zur Hälfte in den beiden Teilen der ringförmigen Basis weiter und erzeugt dort ein zusätzliches Magnetfeld. Dieses Magnetfeld hebt sich zwar aufgrund der unterschiedlichen Stromflussrichtung in der ringförmigen Basis im Bereich der Symmetrieachse der Antenne auf; außerhalb dieser Achse ist die Kompensation dieses Feldes aber unvollständig, und es wird ein zusätzliches Magnetfeld in z-Richtung erzeugt. Dieses Feld ist zwar im wesentlichen nicht relevant für die Erzeugung von Magnetresonanzsignalen, aber unter Betrachtung der spezifischen Absorptionsrate (SAR) beeinflusst es sehr wohl die Gesamtbilanz negativ und muss auch bei der Kopplung zu anderen Antennen ins Kalkül gezogen werden.

Eine Kopplung zu anderen Antennen kann bei diversen gebräuchlichen Antennenkombinationen eintreten, wie man sie z.B. zur "Ganzkörper-MRI" oder zum "kontinuierlichen arteriellen Spinlabeling" (continuous arterial spin labeling, CASL) verwendet. Diese letztgenannte Technik setzt man zur Perfusionsmessung ein, siehe [7]. Hierbei wird neben dem das Gehirn erfassenden Antennengebilde ein zusätzliches Antennengebilde als sogenannte "Labelantenne" (konventionell eine Oberflächenspule) am Hals des Patienten (oder der Versuchsperson bzw. des Versuchstiers) verwendet, um das Blut an der Halsschlagader magnetisch zu markieren (durch Invertierung der Kernmagnetisierung im Blut), um seine anschließende örtliche Verteilung im Gehirn durch MRI darzustellen. Letzteres erfolgt mittels der das Gehirn erfassenden Antenne.

Da das von der ringförmigen Basis einer Helmantenne erzeugte Magnetfeld auch Komponenten senkrecht zur z-Achse besitzt, kommt es zumindest in Bereichen außerhalb der Symmetrieachse zu einer Überlagerung mit dem von den Bügeln erzeugten $B_1$-Feld und somit zu einer Verschlechterung der Homogenität dieses $B_1$-Feldes. Außerdem führen die Ströme der beiden Bügel auch zu einem erheblichen Streufeld außerhalb des Gehirns, was gegebenenfalls die Kopplung zu anderen Antennen (z.B. Labelantennen) verstärkt.

Die Aufgabe der vorliegenden Erfindung besteht darin, ein HF-Antennensystem für Magnetresonanzmessungen so auszubilden, dass bei helmartiger Umgreifung eines zu untersuchenden Objektes der bisher erforderliche Ringleiter entfallen kann. Diese Aufgabe wird erfindungsgemäß durch die im Patentanspruch 1 angegebenen Merkmale gelöst.

Demnach wird die Erfindung realisiert an einem HF-Antennensystem zum Anregen und/oder Erfassen der Magnetresonanz in einem zu untersuchenden Objekt, das einem magnetischen Hauptfeld $B_0$ ausgesetzt ist, welches die Spins des Objektes in einer gewünschten Longitudinalrichtung z ausrichtet, mit mindestens einem ersten Antennengebilde, das als Helmantenne gestaltet ist, indem es mehrere Leitungsabschnitte enthält, die jeweils zum Leiten hochfrequenten Wechselstroms ausgelegt sind und die sich von einem gemeinsamen Scheitelbereich krallenförmig auseinanderstrebend bis zu einem Basisbereich erstrecken, um einen das interessierende Volumen enthaltenden Teil des Untersuchungsobjektes helmartig zu umgreifen. Von den bekannten Antennensystemen dieser Gattung unterscheidet sich das erfindungsgemäße Antennensystem dadurch, dass jeder Leitungsabschnitt als HF-Leitung ausgebildet ist zum Führen einer sich im TEM-Modus oder in einem Quasi-TEM-Modus ausbreitenden Leitungswelle in elektromagnetischer Kopplung mit Spins des zu umgreifenden Untersuchungsobjektes, und dass die elektrische Länge und die Terminierungen der HF-Leitungen so gewählt sind, dass sich bei der Frequenz der Magnetresonanz stehende Wellen in den HF-Leitungen ergeben.

Die erfindungsgemäß ausgebildete Helmantenne kann bezüglich einer oder mehrerer Larmorfrequenzen resonant abgestimmt sein. Sie bringt gewichtige Vorteile gegenüber dem Stand der Technik. Erstens entfällt der bei bekannten Helmantennen erforderliche Ringleiter und die damit verbundenen Probleme. So minimiert sich die unerwünschte Kopplung mit anderen Antennengebilden wie z.B. mit einer Labelantenne, die bei dem oben erwähnten CASL-Verfahren zur Perfusionsmessung verwendet wird. Ferner ergibt sich ein einfacherer Aufbau, eine erhöhte Baufreiheit für audiovisuelle und andere Zusatzgeräte und eine geringere SAR-Belastung.

Ein weiterer Vorteil ist eine überraschende Flexibilität hinsichtlich der Ausleuchtung des interessierenden Volumenbereichs innerhalb des zu untersuchenden Objektes. So können in einer besonderen Ausführungsform der Erfindung die elektrische Länge und die Terminierung sowie Parameter der körperlichen Struktur jeder HF-Leitung derart dimensioniert sein, dass das magnetische Wechselfeld der stehenden Leitungswelle entlang der Länge der HF-Leitungen bei der Magnetresonanzfrequenz ein Intensitätsprofil hat, bei welchem die Kopplung mit den Spins des Untersuchungsobjektes auf den jeweils interessierenden Volumenbereich konzentriert, also gleichsam "fokussiert" ist, wenn die HF-Leitungen das Untersuchungsobjekt helmartig umgreifen. Der Wirkungsgrad bei der gezielten Ausleuchtung des interessierenden Volumenbereichs, der oft nur ein Teil des umgriffenen Gesamtvolumens ist, lässt sich durch diese "Fokussierung" optimieren; Streufelder und unerwünschte Kopplungen mit eventuell vorhandenen anderen Bestandteilen des Magnetresonanz-Messsystems lassen sich minimieren.

Die erfindungsgemäße Ausbildung der Helmantenne zeichnet sich ferner durch einen nach Wunsch modifizierbaren $B_1$-Feldgradienten in z-Richtung aus. So können in besonderer Ausgestaltung der Erfindung die elektrische Länge und die Terminierung sowie Parameter der körperlichen Struktur jeder HF-Leitung derart dimensioniert sein, dass der Gradient der in der besagten longitudinalen Richtung gemessenen Komponente des resultierenden magnetischen Wechselfeldes der Leitungswellen, also der "$B_1$-Gradient", über den interessierenden Volumenbereich einen gewünschten Verlauf hat.

Der gewünschte Verlauf des $B_1$-Gradienten kann z.B. so sein, dass sich dieser Gradient zur Ortscodierung verwenden lässt, anstelle eines von außen aufgeprägten Magnetfeldgradienten mittels gesonderter Gradientenspule. Die Dimensionierung kann aber auch so gewählt sein, dass der $B_1$-Gradient minimal ist, also eine maximale Homogenität des B1-Feldes im interessierenden Volumen erreicht wird. Somit lässt sich ein durch die Geometrie der Leitungsabschnitte bedingter $B_1$-Gradient im Messvolumen zumindest partiell kompensieren. Dies kann z.B. gelingen durch eine derartige Bemessung der elektrischen Länge und der Terminierung jeder HF-Leitung, dass bei der Magnetresonanzfrequenz die Intensität des Wechselstroms auf der HF-Leitung vom Scheitelbereich bis zum Basisbereich kontinuierlich zunimmt.

Die verwendeten HF-Leitungen können im Grunde von beliebigem Typ sein, z.B. Koaxialleitungen, Zweidrahtleitungen oder Streifenleitungen. In bevorzugter Ausführungsform der Erfindung sind die HF-Leitungen als Streifenleitungen ausgebildet.

Die Erfindung baut auf der bekannten Tatsache auf, dass HF-Energie entlang einer HF-Leitung in Form von Leitungswellen geführt wird und dass sich stehende Wellen ausbilden, falls man die Leitung nicht mit einem ohmschen Widerstand terminiert, der gleich dem Wellenwiderstand der Leitung ist. Die Leitungswellen können echte TEM-Wellen sein, bei denen die elektrischen und magnetischen Feldlinien streng transversal (genau orthogonal) zur Leitungslänge verlaufen; solche Wellen ergeben sich z.B. in Koaxialleitungen. Die Leitungswellen können aber auch sogenannte "Quasi-TEM-Wellen" sein, wie sie insbesondere in Streifenleitungen auftreten und bei denen die Felder auch schwache Komponenten in Längsrichtung der Leitung haben. Diese schwachen Komponenten können in den hier behandelten Fällen vernachlässigt werden, so dass für Quasi-TEM-Wellen in genügender Näherung die gleichen Überlegungen wie für echte TEM-Wellen gelten.

Es ist an sich bekannt, für Magnetresonanz-Messungen HF-Antennen zu verwenden, die Abschnitte von HF-Leitungen (transmission lines) als Wellenleiter zum Führen von Leitungswellen enthalten, siehe [8], [9], [10]. Hierbei nutzt man speziell terminierte Koaxialkabelstücke zur Realisierung von Resonanzkreisen. Es ist auch bekannt, solche Leitungsresonator-Antennen in Streifenleitertechnik aufzubauen, siehe [11], [12], [13].

Es lag jedoch nicht nahe, aus diesem Stand der Technik die Erkenntnis zu gewinnen, dass die Verwendung von HF-Leitungen die weiter oben beschriebenen Probleme lösen kann, wie sie speziell bei den bisher bekannten Helmantennen wegen des Ringleiters auftreten. Dass es überhaupt einen Weg gibt, bei einer Helmantenne ohne den störenden Ringleiter auszukommen, war angesichts des bisherigen Entwicklungsgangs von Helmantennen nicht vorhersehbar. Des weiteren war es angesichts des vorstehend zitierten Standes der Technik auch nicht ohne weiteres zu erkennen, dass man durch ausgewählte Bemessung und Terminierung von HF-Leitungen in Magnetresonanz-Antennenanordnungen eine Fokussierung des $B_1$-Feldes auf den interessierenden Volumenbereich erreichen kann. Die Tatsache, dass stehende Leitungswellen zwangsläufig eine ungleichmäßige ("wellige") Stromverteilung entlang den HF-Leitungen und somit eine ungleichmäßige Feldverteilung bewirken, wurde bisher eher als störend angesehen. Somit waren die bisherigen Anstrengungen bei der Verwendung von HF-Leitungen vielmehr darauf gerichtet, die Stromverteilung über die Länge der Gesamt-Antennenanordnung möglichst gleichmäßig zu halten, entweder durch ohmsche Terminierung mit dem Wellenwiderstand oder durch räumlich parallel verlaufende HF-Leitungen mit abwechselnder Kurschluss- und Offen-Terminierung, siehe z.B. [12] und [14]. Dieser durch den Stand der Technik diktierte Aufwand schreckt zusätzlich davon ab, HF-Leitungen in der Praxis als Antennenelemente für Magnetresonanz zu verwenden. Die Erfindung löst sich von dieser Abschreckung augrund der Erkenntnis, dass eine ungleichförmige Stromverteilung nicht immer störend sein muss, insbesondere nicht bei einer anatomisch angepassten Antenne wie einer Helmantenne, sondern sogar gewünschtenfalls vorteilhaft ausgenutzt werden kann.

Zu den Parametern der körperlichen Struktur der HF-Leitungen, deren Dimensionierung zur Erzielung der jeweils gewünschten Feldverteilung im interessierenden Volumen gemäß der Erfindung einbezogen werden können, gehören insbesondere:

a) geometrische Länge, einstellbar durch Wahl des Dielektrikums und/oder diskrete Reaktanzelemente an der HF-Leitung;
b) Kontur bzw. Krümmungsverlauf;
c) im Fall von Streifenleitungen, Breite bzw. Anzahl der Leiterstreifen entlang der Leitung und die Dicke des Dielektrikums.

Durch ortsabhängige Variation mancher dieser Strukturparameter entlang der HF-Leitung kann die Feldverteilung zusätzlich beeinflusst werden. So können z.B. die Dielektrizitätskonstante des Dielektrikums und, bei Streifenleitungen, die Dicke des Dielektrikums und der geometrische Verlauf der Leiterstreifen längs der Leitung einer Funktion folgen, welche zur Erzielung der gewünschten Feldverteilung beiträgt.

In besonderer Ausführungsform der Erfindung enthält das HF-Antennensystem zusätzlich ein zweites Antennengebilde als Labelantenne, die aus einer oder mehreren HF-Leitungen gebildet ist. Vorzugsweise sind auch die HF-Leitungen der Labelantenne hinsichtlich ihrer elektrischen Länge, Terminierung und körperlichen Struktur nach den oben erwähnten Gesichtspunkten dimensioniert, um eine gewünschte Feldverteilung in demjenigen Volumen zu erzielen, das von der Labelantenne zur Magnetresonanz angeregt werden soll.

Die Erfindung und besondere Ausgestaltungen werden nachstehend anhand von weiteren Zeichnungsfiguren 2 bis 14 erläutert.

Fig. 2     zeigt in vier Bildern A bis D die Strom- und Spannungsverteilung entlang einer HF-Leitung bei vier verschiedenen Terminierungen;

Fig. 3     zeigt in drei Bildern A bis C Beispiele der Feldverteilung von Leitungswellen über den Querschnitt von Streifenleitungen unterschiedlichen Aufbaus und bei unterschiedlichen Betriebsmoden;

Fig. 4     zeigt den räumlichen Aufbau einer bevorzugten Ausführungsform einer erfindungsgemäßen Helmantenne;

Fig. 5     zeigt schematisch eine kapazitive Ankopplung der Zuleitung an einer HF-Streifenleitung;

Fig. 6     zeigt schematisch eine induktive Ankopplung der Zuleitung an einer HF-Streifenleitung;

Fig. 7     zeigt das Ersatzschaltbild der induktiven Ankopplung nach Fig. 6;

Fig. 8     zeigt nähere Einzelheiten der Streifenleitungs-Anordnung an den Armen der Helmantenne nach Fig. 4;

Fig. 9     zeigt schematisch eine Einrichtung zur Vertauschung der Terminierung einer Streifenleitung

Fig. 10    zeigt, grob schematisiert, die Intensitätsverteilung des $B_1$-Feldes in einem Phantom-Objekt bei Verwendung einer erfindungsgemäßen Helmantenne bei zwei verschiedenen Terminierungen der Streifenleitungen;

Fig. 11    zeigt eine bevorzugte Geometrie einer erfindungsgemäßen Helmantenne;

Fig. 12    zeigt die Anordnung einer Labelantenne in Kombination mit einer erfindungsgemäßen Helmantenne;

Fig. 13    zeigt eine Variante der Streifenleitungen der Label- antenne;

Fig. 14    zeigt ein Beispiel für die Anschlüsse der Labelantenne nach Fig. 12.

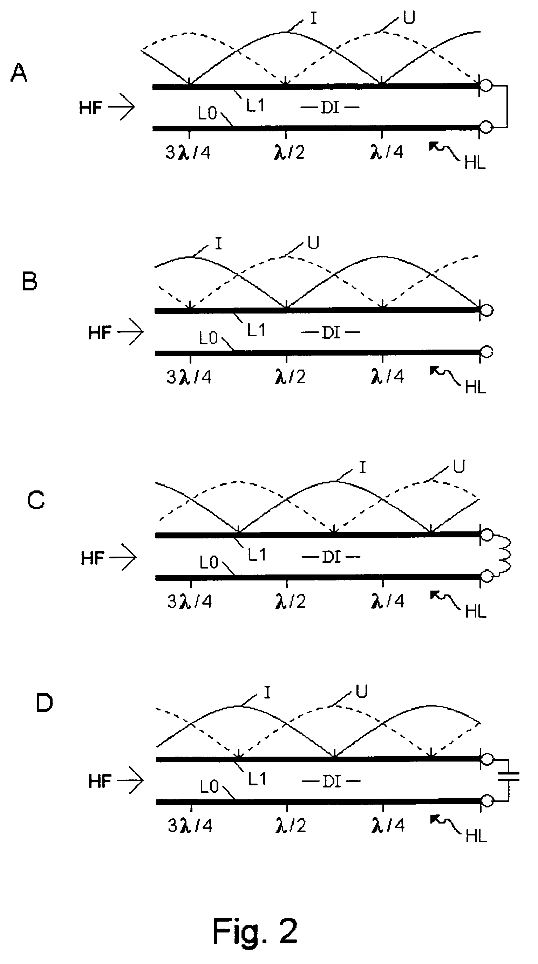

In den Bildern der Fig. 2 ist jeweils eine HF-Leitung HL schematisch durch zwei parallele Leiter L0 und L1 mit einem dazwischen befindlichen Dielektrikum DI dargestellt, das eine relative Dielektrizitätskonstante Er hat. Es sei angenommen, dass die Leitung HL verlustfrei oder so verlustarm ist, dass Leitungsverluste vernachlässigt werden können. Am links liegenden Ursprung der Leitung HL befinde sich ein HF-Generator (nicht gezeigt), der die Leitung HL mit HF-Leistung einer Frequenz f speist, so dass sich in der Leitung HL eine Leitungswelle mit der Wellenlänge

$$\lambda = c_0 / (f * \sqrt{\varepsilon_r})$$

ausbreitet, wobei $c_0$ die Lichtgeschwindigkeit im freien Raum ist.

Das Bild A in Fig. 2 zeigt den Fall, dass die Leitung HL am Ende kurzgeschlossen ist. Bei einer mit Kurzschluss terminierten Leitung kommt zur Ausbildung eines Maximums im Leitungsstrom I am Ende der Leitung. Die Spannung U ist am Terminator in diesem Fall Null. Infolge der Reflexion am Ende bildet sich eine stehende Welle, so dass sich in einer Entfernung von $\lambda/4$ vom Ende die Verhältnisse umkehren, d. h. an dieser Stelle entsteht ein Spannungsmaximum, und der Strom ist Null. Das mit Kurzschluss terminierte $\lambda/4$-Leitungsstück verhält sich wie ein Parallelschwingkreis. Nach einer weiteren Wegstrecke von $\lambda/4$ in Richtung zum Generator, also in einer Entfernung von $\lambda/2$ vom Ende, kehren sich die Verhältnisse erneut um. Das $\lambda/2$-Leitungsstück verhält sich wie ein Serienschwingkreis. Mit Kurzschluss terminierte Leitungsstücke der Länge $\lambda/4$ oder $\lambda/2$ eignen sich also als Resonator.

Ein offenes Ende der HF-Leitung HL reflektiert ebenfalls die gesamte HF-Leistung, so dass sich auch hier eine stehende Welle bildet. Das Bild B in Fig. 2 zeigt die Verteilung von Strom I und Spannung U längs der am Ende offenen Leitung. Diese Verteilung ist gegenüber der im Bild A gezeigten Verteilung um $\lambda/4$ verschoben. Hier ergibt sich Serienresonanz bei einer Leitungslänge von $\lambda/4$ (und einem ungeradzahligen Vielfachen davon) und Parallelresonanz bei einer Leitungslänge von $\lambda/2$ (und einem ganzzahligen Vielfachen davon). Am Ende offene Leitungsstücke dieser Länge eignen sich also ebenfalls als Resonator.

Terminiert man die Leitung mit einer reinen Reaktanz (reine Kapazität oder reine Induktivität), dann kommt es ebenfalls zur Reflexion der gesamten Leistung, da ja bekanntlich eine reine Reaktanz nur Blindleistung aufnehmen kann. Hier entstehen die Serien- und Parallelresonanzen bei Leitungsstücken, deren Länge von ganzzahligen Vielfachen von $\lambda/4$ verschieden ist. Bei einer mit reiner Induktivität terminierten Leitung kann sich z.B. die im Bild C der Fig. 2 schematisch dargestellte Strom-Spannungsverteilung ergeben. Bei einer mit reiner Kapazität terminierten Leitung kann sich z.B. die im Bild D der Fig. 2 schematisch dargestellte Strom-Spannungsverteilung ergeben. Es sei angemerkt, dass man durch Änderung der Größe der Induktivität bzw. Kapazität alle Strom-Spannungsverteilungen zwischen den Grenzfällen "Kurzschluss" und "offene Leitung" einstellen kann.

Aus den vorstehenden Erläuterungen ist ersichtlich, dass man über die Wahl der Terminierung die Strom- und Spannungsverteilung (bezogen auf den Terminierungspunkt als Koordinatenursprung) längs der HF-Leitung verschieben kann. Bei einer erfindungsgemäßen Helmantenne wird dies ausgenutzt, um einen ungewollten geometrisch bedingten HF-Feldgradienten innerhalb des Messvolumens zu minimieren. Dies geschieht dadurch, dass man die Strom- und Spannungsverteilung längs den HF-Leitungsabschnitten der Antenne durch geeignete Wahl der Terminierung so einstellt, dass die Stromverteilung und somit die Verteilung des $B_1$-Feldes einen Gradienten hat, der gegenläufig zu dem ungewollten Gradienten ist.

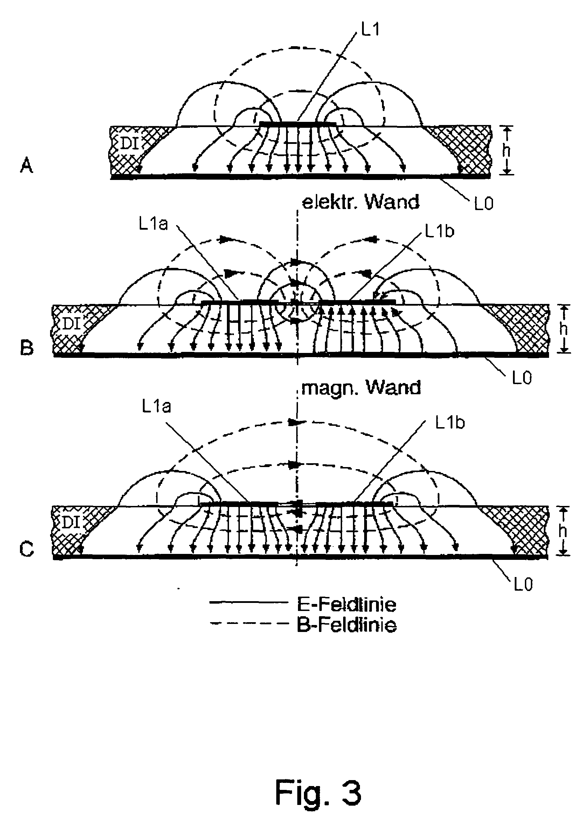

Es ist vorteilhaft, die HF-Leitungsabschnitte einer erfindungsgemäßen Antennenanordnung durch HF-Streifenleitungen zu realisieren, vorzugsweise in Form von Streifen dünner Metallfolien auf gegenüberliegenden Oberflächen eines Trägers aus dielektrischem Material. Aus den bisherigen Erfahrungen beim Design von Antennen weiß man auch, dass es vorteilhaft ist, dünne Folien als Induktivitäten einzusetzen, da es durch die Erhöhung der Stromdichte an den Kanten der Folie zu einer Homogenisierung des $B_1$-Feldes im Messvolumen kommt, siehe [15]. Zudem erreichen dünne Folien eine bessere Unterdrückung unerwünschter Wirbelströme in der Antenne. Bei der erfindungsgemäßen Antenne wird diese Erkenntnis dahingehend weiterentwickelt, dass man zur Homogenisierung des HF-Feldes vorteilhaft mehrere Leitungselemente in gewissem Abstand nebeneinander anordnet. Die zu erwartenden Veränderungen bezüglich der Feldverteilung sind in der Fig. 3 veranschaulicht.

Das Bild A in Fig. 3 zeigt die Feldverteilung über den Leitungsquerschnitt bei Verwendung einer Streifenleiteranordnung, die einen breiteren Leiterstreifen bzw. eine leitende Grundplatte L0 auf der einen (unteren) Seite eines Dielektrikums DI und einen schmalen Leiterstreifen L1 auf der gegenüberliegenden (oberen) Seite des Dielektrikums enthält. Es ist vorteilhaft, die Breite des oberen Streifens nicht größer als das 20-fache der Dicke des Dielektrikums zu bemessen, vorzugsweise wird ein kleinerer Wert gewählt. Das Breitenverhältnis vom oberen und unteren Leiter hat Auswirkung auf die Eindringtiefe des Magnetfelds $B_1$. Unter der Voraussetzung der Verwendung von Dielektrika mit einer Dicke h kleiner als 1 cm ist die Näherung der Ausbildung einer Quasi-Leitungswelle hinreichend gerechtfertigt. Es existieren also im Wesentlichen nur elektrische und magnetische Felder transversal zur Leitungslänge, und zwar mit der im Bild A der Fig. 3 schematisch dargestellte Feldverteilung. Die elektrischen Feldlinien sind als durchgezogenen Linien gezeichnet und die magnetischen Feldlinien sind gestrichelt gezeichnet.

Erweitert man die Anordnung auf zwei Leiterstreifen L1a und L1b an der Oberseite des Dielektrikums DI, so kann man, abhängig vom Schwingungsmodus, die in den Bildern B und C der Fig. 3 dargestellten Feldverteilungen erreichen. Bild B entspricht dem Fall, wo der Strom auf den beiden Leiterstreifen L1a und L1b in entgegengesetzten Richtungen fließt. Aufgrund der daraus resultierenden Spannungsdifferenz zwischen den beiden Leitern kommt es in diesem Fall zur Ausbildung eines elektrischen Feldes (E-Feldes), das die Ebene in der Mitte der Anordnung senkrecht durchdringt. In diesem Fall spricht man von einer elektrischen Wand. Werden beide Leiterstreifen L1a und L1b vom Strom gleichphasig durchflossen, so beobachtet man die im Bild C der Fig. 3 dargestellte Feldverteilung. Diese Betriebsart ist in der Regel die bevorzugte Variante.

Im Allgemeinen lassen sich bei N Leiterstreifen über einer leitenden Grundplatte gleichzeitig N Schwingungsmoden einstellen.

Es wurde gefunden, dass man die in Längsrichtung beobachtete Verteilung des resultieren Gesamtfeldes durch geeignete Auswahl der Terminierungen der einzelnen Leiterstreifen gegenüber der Grundplatte beeinflussen kann. Dies kann in einer besonderen Ausgestaltung der Erfindung ausgenutzt werden, indem die Terminierung so ausgewählt werden, dass sich in Längsrichtung der Streifenleiteranordnung der gewünschte $B_1$-Gradient ergibt, um entweder einen geometrisch bedingten $B_1$-Gradienten im Messvolumen zu kompensieren oder einen Bauch des $B_1$-Feldes konzentriert in den Ortsbereich des Messvolumens zu legen.

An dieser Stelle sei angemerkt, dass der breitere Leiter an der Grundfläche zur Unterdrückung von Wirbelströmen (bedingt durch die Schaltung von $B_0$-Gradienten zur Ortscodierung in der MRI oder der lokalisierten MRS) in schmale Streifen in Längsrichtung mit einzelnen Schlitzen in der Größenordnung von ca. 1 mm aufgeteilt werden kann. Dies ist möglich, da HF-Ströme nur in Längsrichtung der Streifenleitung fließen. Da die Schlitze zwischen den einzelnen Streifen sehr schmal im Vergleich zur Wellenlänge der HF sind, kommt es auch zu keinem nennenswerten Durchgriff der HF. Als weitere Maßnahme zur Unterdrückung von Wirbelströmen kann die Dicke des breiteren Leiters ungefähr gleich der Skintiefe bei der verwendeten Magnetresonanzfrequenz bemessen werden, z.B. im Bereich zwischen dem 1- und 2-fachen der Skintiefe.

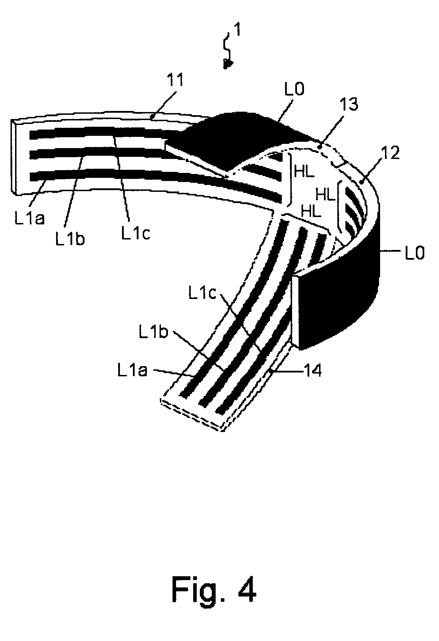

Die Fig. 4 zeigt den räumlich-körperlichen Aufbau einer bevorzugten Ausführungsform einer erfindungsgemäßen Helmantenne 1. Ein Tragkörper aus dielektrischem Material bildet vier streifenförmige Arme 11, 12, 13, 14, die von einem zentralen Scheitelbereich ausgehend in vier um 90° zueinander versetzte Richtungen auseinanderstreben. Die Arme nehmen dabei einen gekrümmten Verlauf, derart dass sie ein Untersuchungsobjekt wie z.B. den oberen Teil eines menschlichen Kopfes krallenartig umgreifen können. Die Außenseite jedes der Arme ("Krallen") 11 bis 14 ist über ihre ganze Fläche mit einem leitenden Belag L0 beschichtet (auch geschlitzt ausführbar zur Unterdrückung unerwünschter Wirbelströme), und auf der Innenseite befinden sich im gezeigten Fall jeweils drei Leiterstreifen L1a, L1b und L1c, die nebeneinander (im gezeigten Fall parallel) und im Abstand zueinander in Längsrichtung des jeweiligen Armes verlaufen. Somit bildet jeder Arm drei räumlich parallele HF-Leitungszüge, die zur Bildung von Leitungsresonatoren terminiert werden können und mit Koppelelementen zum Einkoppeln und/oder Auskoppeln von HF-Leistung versehen werden können. Die Terminierungen und Koppelelemente sind in der Fig. 4 nicht dargestellt.

Die Anzahl der "inneren" Leiterstreifen L1 kann auch gleich 1, 2 oder höher als 3 sein. Die Anzahl ist mitbestimmend für die Breite der Streifenleitungen. Einerseits sollte genügend Raum zwischen den Krallen frei bleiben, um ausreichend Platz für audiovisuelle oder sonstige Zusatzgeräte (Videobrille, Kopfhörer, etc.) zu haben; andererseits ist die Homogenität des Feldes umso besser, je größer die Anzahl der inneren Leiterstreifen bzw. deren Breite ist. Die Anzahl von drei Leiterstreifen kann einen guten Kompromiss zwischen diesen Forderungen liefern.

Der in Fig. 4 gezeigte Aufbau kann hergestellt werden, indem zunächst ein ebenes Kreuz aus einer Platte eines dielektrischen Materials wie z.B. Polypropylen (PP-Platte) ausgeschnitten wird. Soll die Helmantenne weniger oder mehr als vier Arme haben, kann statt eines Kreuzes ein Stern mit einer entsprechenden Anzahl von Armen ausgeschnitten werden. Anschließend wird das PP unter Wärmezufuhr zum Beispiel über einen rotationssymmetrischen Formkörper gebogen. Der Formkörper kann z.B. domförmig, topfähnlich oder kegelförmig sein bzw. irgendeine Zwischenform annehmen, wenn dies für die Ausbildung eines bestimmten Feldgradienten oder die Anpassung an eine besondere Objektform erforderlich ist. Es sei angemerkt, dass die optimalen Werte sowohl der Breite der Arme, deren Dicke als auch deren Länge von der Form des Untersuchungsobjekts abhängen. Geeignet für Untersuchungen des menschlichen Gehirns ist beispielsweise eine Dicke des Dielektrikum-Körpers von ca. 0,5 cm, eine Armbreite von ca. 7 cm und eine Armlänge von ca. 23 cm. Das Material für den Dielektrikum-Körper ist ebenfalls in weiten Grenzen frei wählbar. Es sollte möglichst hinsichtlich seiner elektrischen Eigenschaften (z.B. der Dielektrizitätskonstante $\varepsilon_r$ und des Verlustfaktors) in der Größenordnung zu PP vergleichbare oder bessere Werte aufweisen und in der gewünschten Form herstellbar sein.

Hier sei erwähnt, dass bei Streifenleitungen die Dicke des Dielektrikums ein Parameter ist, der ebenfalls gezielt bemessen werden kann, um zur Realisierung einer gewünschten Feldverteilung im interessierenden Volumen beizutragen. Nach jüngst veröffenlichen Berechnungen nimmt bis zu einer Dicke von ca. 6 cm die Eindringtiefe des Feldes im Untersuchungsobjekt mit wachsender Dicke des Dielektrikums zu, siehe [16].

Der Dielektrikum-Körper kann selbstverständlich auch auf andere Weise geformt werden bzw. aus einem anderen hochwertigen Dielektrikum geformt werden. Bei der Formung sollten sich die Eigenschaften des Dielektrikums nicht merklich verschlechtern, um hinreichend verlustfreie HF-Leitungen realisieren zu können. Dies ist wichtig, damit man die Wellenausbreitung längs der Wellenleiter näherungsweise zweidimensional betrachten kann, siehe z.B. [17].

Falls man den Aufwand der Herstellung einer komplizierten Form für den Grundkörper jedoch scheut, so können zur Bildung des dielektrischen Trägers auch vier (bzw. mehr oder weniger) getrennte PP-Platten mit einer Breite von z.B. 7 cm, einer Länge von z.B. 20 cm und einer Dicke von z.B. 0,5 cm, verwendet werden, die an einem Ende durch geeignete Mittel zusammengehalten werden.

Es ist bekannt, dass symmetrisch zur Erde angesteuerte Antennen zu einer geringeren Wechselwirkung mit der Umgebung führen und dass es bei in Quadratur betriebenen Antennen zu einer Halbierung der erforderlichen Sendeleistung kommt, und dass sich im Empfangsfall das SNR um den Faktor 1,4 erhöht. Aus diesem Grund fasst man in vorteilhafter Ausführungsform jeweils zwei gegenüberliegende Arme der Antenne elektrisch zu einer Gruppe zusammen und steuert sie symmetrisch zur Erde an. Die um 90° (bzw. 270°) versetzten Arme werden ebenfalls zu einer weiteren Gruppe zusammengefasst und mit einer um 90° phasenverschobenen, bezüglich des Erdpotentials symmetrischen Spannung angesteuert. Es sei angemerkt, dass es sich hierbei lediglich um eine vorteilhafte Gestaltungsvariante handelt.

Eine erfindungsgemäße Antenne kann auch mit nur zwei gegenüberliegenden Armen aufgebaut und betrieben werden. Es ist auch möglich, verschiedene Arme der Antenne auf unterschiedliche Frequenzen abzustimmen und somit eine Antenne zu schaffen, die für die Untersuchung mehrerer Kerne genutzt werden kann (z.B. bei der Anwendung einer protonenentkoppelten $^{13}$C-Spektroskopie oder anderer Entkopplungsexperimente oder bei Korrelations- oder Separationsexperimenten mit zwei oder mehreren Kernsorten).

Schließlich sei angemerkt, dass eine erfindungsgemäße Antenne auch grundsätzlich als parallele Sendeantenne, als parallele Sende/Empfangsantenne oder als parallele Empfangsantenne verwendet werden kann, wenn jedes Antennenelement oder jede Gruppe von Antennenelementen mit eigenen Sende- und Empfangskanälen versehen wird. Weiterhin kann man eine erfindungsgemäße Antenne natürlich auch in ihrer Größe für andere Messungen anpassen, indem man beispielsweise Materialien mit anderen dielektrischen Eigenschaften benutzt bzw. zusätzlich diskrete Bauelemente einfügt, um die elektrische Länge der HF-Leitungen zu variieren.

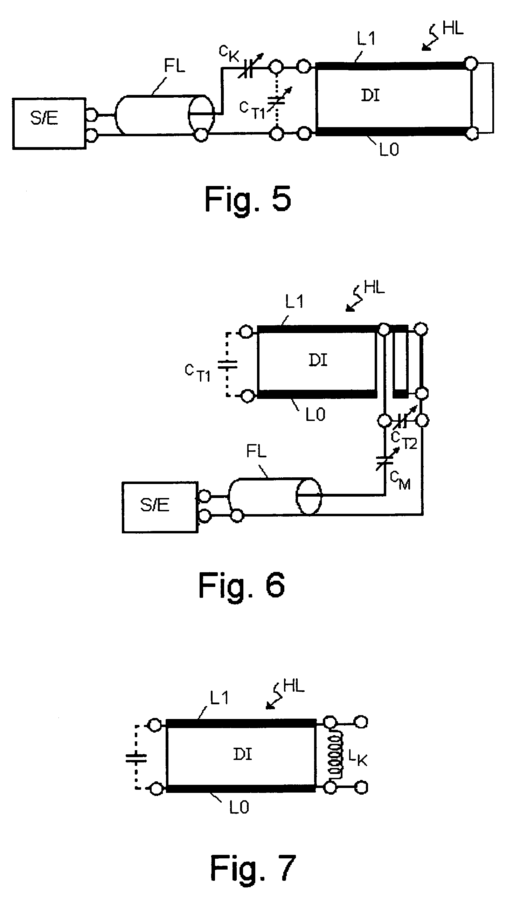

Für die Ankopplung der aus den Streifenleitungen gebildeten Resonatoren an den HF-Sender (für Sendebetrieb) oder an den Empfänger (für Empfangsbetrieb) oder an einen Sender/Empfänger seien im Folgenden zwei Varianten anhand der Figuren 5 bis 7 exemplarisch beschrieben. Es ist auch eine gemischte kapazitive/induktive Kopplung denkbar, wie sie beispielsweise bei Bandfiltern verwendet wird. Die HF-Streifenleitung HL ist in diesen Figuren im Längsschnitt dargestellt und besteht im gezeigten Fall aus zwei Leiterstreifen L0 und L1 mit einem dazwischen befindlichen Dielektrikum DI, ähnlich wie in den Darstellungen der Fig. 2. Der Leiterstreifen L0 sei der an Masse oder Erde angeschlossene Leiter und entspricht z.B. dem "breiten" oder geschlitzten Metallbelag L0 auf der Außenfläche eines der in Fig. 4 gezeigten Arme 11 bis 14.

Wie bereits anhand der Fig. 2 erläutert wurde, beobachtet man bei Streifenleitungen, die nicht mit dem Wellenwiderstand terminiert sind, stehende Wellen. Strom und Spannung sind dabei um 90° in der Phase verschoben. Falls die Leitung HL hinsichtlich ihrer Länge nicht genau auf die entsprechende Resonanzfrequenz abgestimmt ist, kann eine geeignete Reaktanz wie z.B. ein quer geschalteter "Tune"-Kondensator $C_{T1}$ zur Feinabstimmung verwendet werden, wie gestrichelt in den Figuren 5 bis 7 gezeichnet. Dieser Kondensator "verkürzt" die geometrische Länge, die für die Leitung benötigt wird, um die gewünschte elektrische Länge zu erreichen. Eine solche Verkürzung ist sinnvoll, um die geometrische Abmessung der als Antennenelemente verwendeten HF-Leitungen an die Abmessung des interessierenden Volumenbereichs des zu untersuchenden Objektes besser anzupassen. Genau so gut ist mittels entsprechend geeigneter reaktiver Elemente und geeigneter Wahl ihrer Einfügungsart auch gewünschtenfalls eine Verlängerung der Leitung möglich. Natürlich ist es auch möglich, das Verhältnis zwischen elektrischer und geometrischer Länge durch spezielle Bemessung des ER-Wertes des Dielektrikums einzustellen.

Es ist vorteilhaft, in jedem Fall die Möglichkeit einer gewissen Feinabstimmung zu schaffen, um neben Fertigungstoleranzen auch Beladungseffekte ausgleichen zu können. Bei einer aus HF-Leitungen gebildeten Antenne stehen die Felder der Leitungswellen in Wechselwirkung mit dem Untersuchungsobjekt, welches die "Beladung" der Antenne bildet. Diese Beladung ist nicht ganz ohne Einfluss auf die Wellenlänge und somit auf die elektrische Länge der HF-Leitung. Es empfiehlt sich deswegen, bei der Bemessung der geometrischen Länge der HF-Leitung darauf zu achten, dass ein gewisser Spielraum besteht, um nach Beladung der Antenne die elektrische Länge durch Tune-Reaktanzen genau auf das gewünschte Maß justieren zu können. Wenn also hier von einer bestimmten elektrischen Länge als Betriebsparameter gesprochen wird, dann ist damit die elektrische Länge gemeint, die sich bei Beladung der Antenne ergibt.

Eine kapazitive Ankopplung erfolgt am effektivsten in der Umgebung des Spannungsmaximums (bei einer am Ende kurzgeschlossenen λ/4-Leitung ist dies das dem Kurzschluss gegenüberliegende Ende). Das Prinzip der kapazitiven Ankopplung ist schematisch in Fig. 5 gezeigt. Die Ankopplung an den Sender/Empfänger S/E erfolgt über einen Koppelkondensator $C_K$, der auch zweckmäßigerweise noch für die erforderliche Anpassung des Wellenwiderstands der (im gezeigten Fall koaxialen) Zuleitung FL an den Widerstand des mit der Streifenleitung HL gebildeten Resonanzkreises sorgt und zu diesem Zweck justierbar ist.

Möchte man den Sender bzw. Empfänger S/E induktiv an den Streifenleitungs-Resonator HL ankoppeln, so wählt man hierzu zweckmäßigerweise den Bereich in der Nähe des Strommaximums und positioniert dort eine Koppelschleife oder -spule. Für eine am Ende kurzgeschlossene Streifenleitung ist dies der Bereich in der Umgebung des Kurzschlusses. Das Schema der induktiven Ankopplung an den Schwingkreis ist schematisch in Fig. 6 dargestellt. Am einfachsten bewerkstelligt man die induktive Ankopplung, indem man in einem geringen Abstand vom Kurzschluss eine Bohrung von der den Leiter L0 tragenden Seite durch das Dielektrikum DI hindurch zum Leiterstreifen L1 vorsieht. Innerhalb dieser Bohrung führt man einen Anschlussdraht vom Leiterstreifen L1 zum Innenleiter der koaxialen Zuleitung FL. Dieser Anschlussdraht bildet mit dem kurzgeschlossenen Ende der Streifenleitung HL eine Koppelschleife, die zu dem restlichen Teil der Streifenleitung parallel geschaltet ist. Die Fig. 7 zeigt das Ersatzschaltbild für die Koppelschleife als Induktivität $L_K$. Über die Größe der Koppelschleife kann man eine Widerstandstransformation erreichen. Die Koppelschleife kann über einen weiteren, parallelgeschalteten Tune-Kondensator $C_{T2}$ auf die gewünschte Resonanzfrequenz abgestimmt werden. Für die Anpassung an das Koaxialkabel zum Sender/Empfänger kann eine justierbare Kapazität $C_M$ als "Matching"-Kondensator dienen.

Nachstehend werden Beispiele gegeben für die körperliche und elektrische Dimensionierung und für die Anschlussweise der in Fig. 4 gezeigten Antennenanordnung, um diese Anordnung als Quadratur-Helmantenne zur Untersuchung des menschlichen Gehirns verwenden zu können. Zunächst zur körperlichen Dimensionierung:

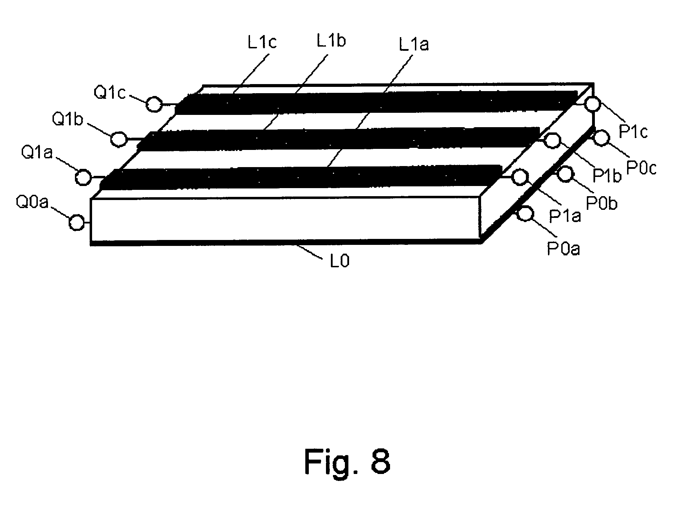

Bei einer als Prototyp hergestellten Anordnung wurde die Außenseite der vier Arme 11, 12, 13, 14 gemäß Fig. 4 in der ganzen Breite mit einer dünnen leitfähigen Schicht L0 aus selbstklebender Cu-Folie beschichtet. Es sei an dieser Stelle darauf hingewiesen, dass eine Foliendicke in der Größenordnung der Skintiefe bei der HF (z.B. 5 bis 25 $\mu$m), aufgrund einer Dämpfung unerwünschter Wirbelströme vorteilhaft ist. Anschließend wurden auch auf der Innenseite an den dafür vorgesehenen Stellen mit selbstklebender Cu-Folie leitfähige Schichten aufgebracht. Symmetrisch zur Längsmittellinie der Arme sind bei diesem Prototyp die drei Leiterstreifen L1a, L1b, L1c Streifen aus selbstklebender Cu-Folie aufgeklebt. Zur näheren Veranschaulichung der körperlichen Merkmale und der räumlichen Dimensionen zeigt die Fig. 8 einen der vier Antennenarme 11 bis 14 über den Abschnitt, der die Leiterstreifen L1a, L1b, L1c enthält. Zur Vereinfachung der Darstellung ist dieser Abschnitt, der in Wirklichkeit meist gebogen ist, in gerader Abwicklung gezeigt.

An einem Ende sind die Leiterstreifen L1a, L1b, L1c mit Terminierungsanschlüssen P1a bzw. P1b bzw. P1c versehen, die jeweils ein Anschlusspaar mit entsprechend angeordneten Terminierungsanschlüssen P0a, P0b, P0c des "Grundleiter" L0 bilden. Am anderen Ende befindet sich eine ähnliche Anordnung von Anschlüssen Q1a, Q1b, Q1c an den Leiterstreifen L1a, L1b, L1c und von Anschlüssen Q0a, Q0b, Q0c am Grundleiter L0. Die genannten Anschlüsse sind nur symbolhaft dargestellt, um das Vorhandensein irgendeiner beliebigen elektrischen Anschlussmöglichkeit zu symbolisieren.

Die Streifenbreite wurde in Abhängigkeit von der gewählten Dicke des Dielektrikums (0,5 cm), dem gewünschten Wellenwiderstand (etwa 80 Q) und dem gewünschten Feldprofil berechnet. Richtlinien zum Design findet man in der Literatur, siehe z.B. [18], [19], [20]. Bei dem hier vorgestellten Beispiel beträgt die Streifenbreite 0,7 cm. Der Abstand zwischen den Leiterstreifen L1a, L1b, L1c ist 1,5 cm. Für die ins Auge gefasste Anwendung stellt eine Breite b jedes Arms von ca. 7 cm einen guten Kompromiss hinsichtlich Homogenität des $B_1$-Feldes und bezüglich der gewünschten Baufreiheit für zusätzliche audiovisuelle Zusatzgeräte dar. Für die Dicke sowohl der inneren als auch der äußeren Leiterstreifen erweist sich ein Maß von etwa 18 $\mu$m als vorteilhaft. Die Länge der Leiterstreifen wurde hinsichtlich der angestrebten Erfassung des gesamten Gehirns auf 23 cm festgelegt.

Hier sei angemerkt, dass sich die erfindungsgemäße Antennenanordnung auch mit davon abweichend dimensionierten Streifenleitungen sowie mit einer anderen Anzahl von Streifenleitern realisieren lässt. Weiterhin sei angemerkt, dass das Dielektrikum für die Streifenleitungen auch Luft (bzw. Vakuum) sein kann. In diesem Fall müssten die leitenden Schichten selbsttragend ausgeführt werden oder auf der Gegenseite jeweils mittels eines Dielektrikums stabilisiert werden. Neben PP kommen natürlich auch andere Dielektrika wie z.B. Teflon (bzw. Teflon mit verschiedenen Einlagerungen von Keramikpulver) und andere verlustarme Substrate in Frage. Anstelle der selbstklebenden Cu-Folie sind natürlich auch andere Verfahren zur Aufbringung von Metallisierungen anwendbar.

Durch zielgerichtete Wahl der elektrischen Anschlussweise und Terminierung der Streifenleitungen kann man die Strom- und Spannungsverteilung längs der Streifenleitungen so einstellen, dass sich eine gewünschte $B_1$-Feldverteilung über den von der Helmantenne umgriffenen Bereich des Untersuchungsobjektes ergibt. Nachstehend seien mehrere verschiedene Varianten für die Anschlussweise und Terminierung der in den Figuren 4 und 8 gezeigten Antennenanordnung beschrieben, um aufzuzeigen, wie sich die verschiedenen Strom- und Spannungsverteilungen erzielen lassen.

Bei einer ersten Variante sind die drei Streifenleitungen jedes Arms, die jeweils aus einem der Leiterstreifen L1a, L1b, L1c und dem "Grundleiter" L0 bestehen, am einen Ende kurzgeschlossen, d.h. es besteht Kurzschlussverbindung z.B. an den Anschlusspaaren P0a-P1a, P0b-P1b, P0c-P1c. Am anderen Ende sind zur Vereinfachung der Abstimmung alle Enden der jeweils drei zu einer Gruppe gehörenden Leiterstreifen L1a, L1b, L1c direkt miteinander verbunden, d.h. es besteht Kurzschlussverbindung zwischen den Anschlüssen Q1a, Q1b, Q1c.

Die Kopplung zum HF-Sender bzw. -Empfänger S/E erfolgt bei dieser Variante vorzugsweise kapazitiv, gemäß der Darstellung in Fig. 5. Es sei hier angemerkt, dass die Verbindung zum Tune-Kondensator $C_{T1}$ auch über ein kurzes Semi-Rigid-Kabel (beim hier behandelten Beispiel ca. 6 cm lang) erfolgen kann. Das Kabel kann auch in einer anderen Länge ausgeführt werden. Es sollte aber kürzer als $\lambda/4$ sein.

Die Streifenleitungen zweier diametral gegenüberliegender Arme (z.B. der Arme 11 und 12 gemäß Fig. 4) werden mit einem 180°-Phasensprung an den selben Tune-Kondensator $C_{T1}$ angeschlossen und über den selben abstimmbaren Koppelkondensator $C_K$ mit dem koaxialen Zuleitungskabel FL verbunden. Die Abstimmung und Anpassung erfolgt nach dem in Fig. 5 veranschaulichten Prinzip. Den 180°-Phasensprung wählt man vorzugsweise, damit das von beiden Schenkeln erzeugte Magnetfeld dieselbe Richtung hat und sich in dem Überlappungsbereich addiert. Im entgegengesetzten Fall erhält man eine Feldverteilung analog zu einer Maxwellverteilung. In diesem Fall würde das Signal im Zentrum unterdrückt. In gleicher Weise erfolgt die elektrische Verbindung der Streifenleitungen der beiden anderen Arme (also der Arme 13 und 14) unter Verwendung eines gemeinsamen Tune-Kondensators und eines gemeinsamen Koppelkondensators mit einem zweiten koaxialen Zuleitungskabel (nicht dargestellt).

Die beiden Zuleitungskabel werden über einen Hybridkoppler mit dem Sender bzw. Empfänger gekoppelt, so dass sich ein Phasenunterschied von 90° der HF-Leistungskomponenten ergibt, die beim Sendebetrieb in die beiden Kanäle übertragen werden. Beim Empfangsbetrieb werden die Signale aus den beiden Kanälen am Empfänger addiert. Es ist natürlich auch möglich, den Hybridkoppler und einen geeigneten Vorverstärker direkt am Antennenaufbau anzuordnen oder, bei einer reinen Empfangsantenne, jede Streifenleitung direkt mit einem Vorverstärker auszurüsten. Im Anschluss an die Vorverstärker werden die Signale der einzelnen Antennen konstruktiv addiert.

Bei einer zweiten Variante erfolgt die Ankopplung an den Sender bzw. Empfänger S/E induktiv, wie es in Fig. 6 veranschaulicht ist, wobei die Streifenleitungen mit Kurzschlüssen an einem Ende terminiert sind. Am anderen Ende sind die Streifenleitungen mit dem Tune-Kondensator $C_{T1}$ abgeschlossen. Als Tune-Frequenz wird z.B. die Larmorfrequenz für Protonen bei einer Hauptfeldstärke $B_0$ von etwa 3 T gewählt (ca. 125 MHz). Es sei hier angemerkt, dass die Leiterkreise selbstverständlich auch auf die Larmorfrequenz für Protonen bei höheren $B_0$-Feldstärken oder auch auf die Larmorfrequenz für andere Spezies mit einem von Null verschiedenen Kernspin abgestimmt werden können. Es soll weiterhin angemerkt werden, dass zur Erfüllung der Resonanzbedingung auch zusätzlich entsprechend dimensionierte diskrete Reaktanzen an verschiedenen Stellen der Streifenleitungen angebracht werden können.

Die induktive Ankopplung der mit den Streifenleitungen gebildeten Resonatoren an das Ansteuernetzwerk (Zuleitungen FL und Sender/Empfänger S/E) erfolgt zweckmäßigerweise in der Nähe des Stromknotens, da hier die induktive Kopplung besonders effektiv ist (vgl. Fig. 6). Durch die Wahl der Länge der Koppelstrecke zwischen Kurzschluss und Ankoppelpunkt stellt man ein, wie stark der Resonator durch das Ansteuernetzwerk bedämpft wird und wie sich der Resonanzwiderstand transformiert. Der Kondensator $C_{T2}$ für das Feintuning kann parallel zur Koppelschleife angeschlossen werden. Des Weiteren kann man die justierbare Serienkapazität $C_M$ geeigneter Größe als Matching-Kondensator einfügen.

Mittels der ersten beiden Varianten kann die Strom- und Spannungsverteilung längs der Streifenleitung gespiegelt werden, und zwar durch Vertauschung der Orte von Ankoppelung und Terminierung.

Bei einer dritten Variante sind die Streifenleitungen kapazitiv terminiert, und die Ankoppelung an das Ansteuernetzwerk erfolgt kapazitiv gemäß Fig. 5. Das heißt, z.B. an den in Fig. 8 gezeigten Anschlusspaaren P1a-P0a, P1b-P0b, P1c-P0c ist jeweils ein Terminierungskondensator (nicht gezeigt) vorgesehen. Am anderen Ende sind die drei Leiterstreifen L1a, L1b, L1c direkt miteinander verbunden. Mit dieser Anordnung kann man erreichen, dass sich das Strommaximum der Streifenleitungen zum mittleren Bereich der Streifenleiter hin verschiebt. Durch Variation der Terminierungskapazität und der Tune-Kapazität $C_{T1}$ kann das Profil der Strom- und Spannungsverteilung längs der Streifenleiter verschoben werden.

Bei einer vierten Variante sind die Streifenleitungen an einem Ende induktiv terminiert, wobei jeweils eine Spule als Terminator verwendet wird. Das heißt, an den in Fig. 8 gezeigten Anschlusspaaren P1a-P0a, P1b-P0b, P1c-P0c ist jeweils eine Terminierungsspule (nicht gezeigt) vorgesehen. Am anderen Ende sind die drei Leiterstreifen L1a, L1b, L1c direkt miteinander verbunden und über einen Koppelkondensator mit dem Innenleiter einer koaxialen Zuleitung verbunden. Durch Variation der Terminierungs-Induktivität und der Tune-Kapazität kann man mit dieser Anordnung ebenfalls erreichen, dass die Strom- und Spannungsverteilung längs der Streifenleitung verschoben wird. In diesem Fall lässt sich das das Spannungsmaximum zum mittleren Bereich der Streifenleiter hin verschieben.

Bei allen vorstehend beschriebenen Varianten kann die jeweils erwähnte Terminierung am "halsseitigen" Ende der Streifenleitungen vorgesehen sein (also an demjenigen Ende, das dem Hals der zu untersuchenden Person zugewandt ist, wenn die Helmantenne den Kopf umgreift), oder am gegenüberliegenden "scheitelseitigen" Ende. Es ist auch möglich, jedes Ende zumindest einer der Streifenleitungen in gleicher Weise offen, kurzgeschlossen oder reaktiv zu terminieren und eine Umschalteinrichtung vorzusehen, um das zweite Ende wahlweise in seiner elektrischen Funktion mit dem ersten Ende zu vertauschen.

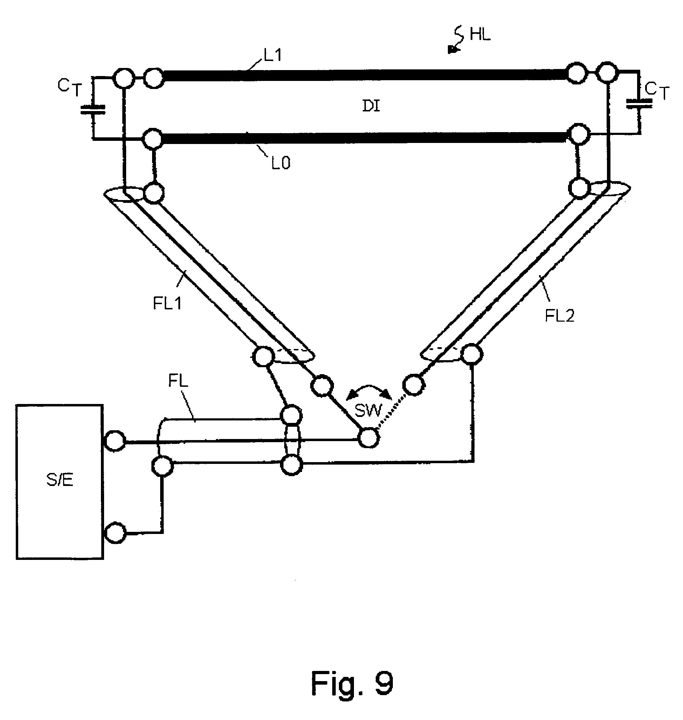

Als Beispiel für eine solche Vertauschungsmöglichkeit zeigt die Fig. 9 eine Anordnung, die ein Umschalten der Streifenleitungen zwischen zwei Anschlussarten mit Kurzschluss-Terminierung erlaubt. Jedes der beiden Enden der Streifenleitung weist einen quergeschalteten Tune-Kondensator $C_T$ auf und ist an eine gesonderte koaxiale Zweig-Zuleitung FL1 bzw. FL2 angeschlossen, und zwar durch Verbindung des Grundleiters L0 der Streifenleitung mit dem Außenleiter und durch Verbindung aller Leiterstreifen L1a, L1b, L1c mit dem Innenleiter der betreffenden Zweig-Zuleitung. Beide Zweig-Zuleitungen FL1 und FL2 haben eine elektrische Länge gleich einem ungeradzahligen Vielfachen $m \geq 1$ einer Viertelwellenlänge $\lambda/4$ und zweigen über einen Umschalter SW von einer koaxialen Haupt-Zuleitung FL0 ab, die mit dem Sender/Empfänger S/E verbunden ist. Um den Kurzschluss als Terminierung an einem gewünschten Ende der Streifenleitung HL herzustellen, wird der Umschalter SW so eingestellt, dass die betreffende Zweig-Zuleitung am Ort des Umschalters SW offen ist, was sich über die m*λ/4-Länge in einen Kurzschluss am zugeordneten Ende der Streifenleitung transformiert. Somit entstehen an dieser Stelle ein Strombauch und ein Spannungsknoten. Auf der Gegenseite wird die Streifenleitung mit dem Tune-Kondensator $C_T$ auf die gewünschte Resonanzfrequenz abgestimmt.

Durch Umschalten des Umschalters SW kann man die Rolle der beiden Enden der Streifenleitung vertauschen. Hierdurch wird die Strom- und Spannungsverteilung längs der Streifenleitung HL gespiegelt. Man ist somit in der Lage, den Gradienten des $B_1$-Feldes während der Experimente zu verändern. Dieses Beispiel soll verdeutlichen, dass man mit einer erfindungsgemäßen Antenne nicht nur den Gradienten des $B_1$-Feldes den experimentellen Wünschen anpassen kann, sondern dass es sogar möglich ist, dieses Profil innerhalb eines Experimentes umzuschalten, z.B. durch Verwendung schneller Schaltdioden als Umschalter SW. Statt der gezeigten Anordnung, die einen einfachen Umschalter SW am Innenleiter der Zuleitungs-Verzweigung enthält, sind natürlich auch aufwendigere Anordnungen mit PIN-Dioden möglich.

Weitere Varianten der Anschluss- bzw. Betriebsweise der erfindungsgemäßen Helmantenne bestehen darin, verschiedene Arme der krallenförmigen Antennenanordnung auf unterschiedliche Larmorfrequenzen abzustimmen. So können z.B. die Streifenleitungen zweier diametral gegenüberliegender Arme auf die Larmorfrequenz einer ersten Kernsorte abgestimmt sein, während die Streifenleitungen des anderen, um 90° versetzten Armpaares auf die Larmorfrequenz einer anderen Kernsorte abgestimmt sind. Beide auf jeweils einem Paar gegenüberliegender Arme gebildete Teilantennen werden voneinander entkoppelt und können zur Untersuchung verschiedener Spezies während eines Experiments genutzt werden. Es ist aber auch möglich, für die Abstimmung der Leitungskreise Netzwerke einzusetzen [23], die beispielsweise aus einem Parallelschwingkreis (Tank) und einem in Reihe geschalteten Kondensator bestehen. Der in Reihe geschaltete Kondensator bestimmt die niedere Resonanzfrequenz der Streifenleitung, während über die Resonanzfrequenz des Tankkreises die obere Resonanzfrequenz der Streifenleitung bestimmt wird. Man kann ein derartiges Netzwerk auch mit mehreren Tankkreisen zur Abstimmung versehen. Damit kann man erreichen, dass jede Streifenleitung bei mehreren Larmorfrequenzen in Resonanz ist. Nach diesem Prinzip kann man auch erfindungsgemäße Antennen realisieren, die in Quadratur betrieben werden und gleichzeitig für mehrere Larmorfrequenzen genutzt werden können. Wenn die Larmorfrequenzen dicht beieinander liegen, sind natürlich Varianten möglich, wo man beispielsweise die überkritische Kopplung zwischen Resonanzkreisen zur Einstellung der unterschiedlichen Larmorfrequenzen nutzt [23].

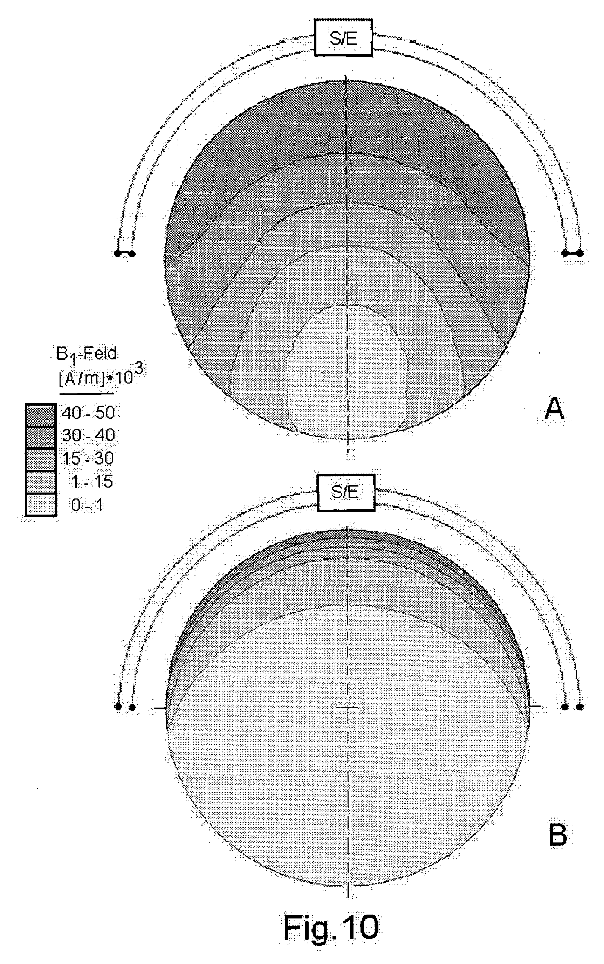

Zum Nachweis der vorteilhaften Eigenschaften einer erfindungsgemäßen Helmantenne wurde eine domartige (etwa halbkugelige) Form der Antennenanordnung mit vier um 90° versetzten Armen aus HF-Streifenleitungen ähnlich der Ausführungsform nach Fig. 4 zugrunde gelegt, mit jeweils einer elektrischen Länge von λ/4, und die Intensitätsverteilung des $B_1$-Feldes innerhalb eines kugelförmigen Phantom-Objektes, das einen menschlichen Kopf simuliert, wurde durch numerische Berechnung abgeschätzt. Die Fig. 10 zeigt in zwei Bildern A und B grob schematisiert die Ergebnisse für zwei verschiedene Terminierungen: einmal für Kurzschluss-Terminierung (Bild A) und einmal für "offene" Terminierung (Bild B). In der Fig. 10 sind verschiedene Intensitätsbereiche von $B_1$-Feldstärken durch verschiedene Graustufen abgebildet, wobei der "Maßstab" für diese Darstellungsart durch die Graustufenskala links in der Figur dargestellt ist.

Das Bild A in Fig. 10 zeigt, dass bei kurzgeschlossener Terminierung das $B_1$-Feld deutlich auf die scheitelseitige Hälfte des Objektes konzentriert ist, also auf denjenigen Volumenbereich des Kopfes, der interessiert, wenn das gesamte Großhirn untersucht werden soll. In diesem Bereich ist außerdem der Gradient des $B_1$-Feldes gering, es ergibt sich dort also eine relative Homogenität des $B_1$-Feldes, wie sich an der geringen Anzahl unterschiedliche Graustufen innerhalb des Bereiches zeigt. Zum halsseitigen Ende hin ergibt sich ein wesentlich schwächeres Feld, wie erwünscht.

Das Bild B in Fig. 10 offenbart hingegen, dass bei offener Terminierung ein starkes $B_1$-Feld nur nahe den Außenrändern in der scheitelseitigen Hälfte des Objektes existiert und dass die Feldstärke sehr rasch zum Inneren hin abnimmt. Diese Terminierung ist also für Ausleuchtung des gesamten Großhirns nicht sinnvoll, kann aber zweckmäßig sein, wenn Randbereiche wie etwa die Großhirnrinde oder der Raum zwischen Gehirn und Schädelknochen oder die oberen Schädelknochen selbst gezielt untersucht werden sollen.

Die in Bild A der Fig. 10 gezeigte Feldverteilung lässt sich durch besondere Modifikationen der Terminierung und/oder des geometrischen Verlaufs der HF-Leitungen weiter optimieren, je nach Anwendungsfall. Für Messungen am Gehirn kann der $B_1$-Feldgradient noch weiter verringert werden, indem man die HF-Leitungen an den halsseitigen Enden mit Induktivitäten terminiert. Dabei verringert sich allerdings das Magnetfeld im mittleren und oberen Bereich des Gehirns. Es auch möglich, die Form der Helmantenne im oberen Bereich "flacher" zu machen, z.B. durch elliptische Krümmung der HF-Leitungen (Ellipsoidform des oberen Bereichs) oder sogar annähernd rechteckiger Krümmung der HF-Leitungen (Topf- oder Zylinderform der Helmantenne).

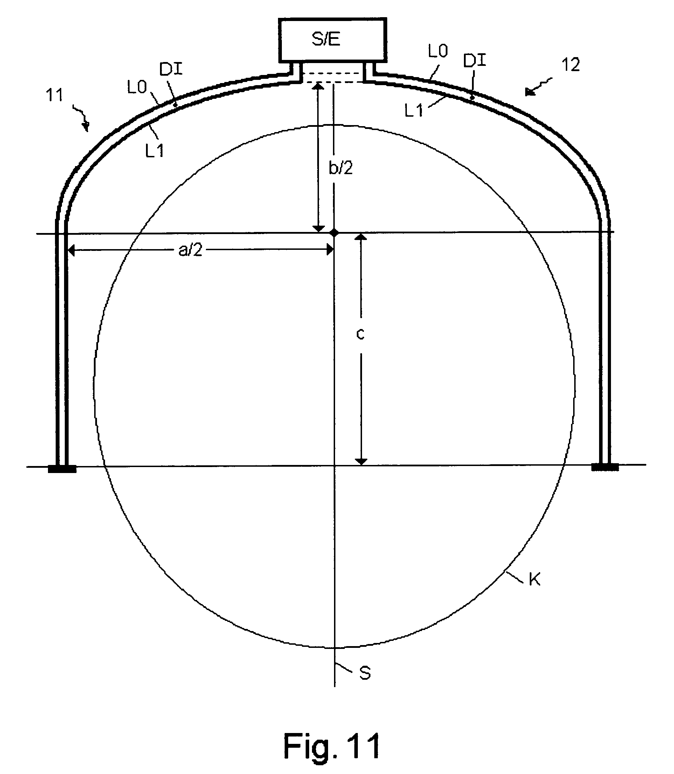

Nachstehend wird anhand der Fig. 11 eine beispielhafte Dimensionierung der erfindungsgemäßen Helmantenne für Untersuchungen am menschlichen Gehirn beschrieben, d.h. das interessierende Volumen ist die das Hirnvolumen umfassende Kalotte des Kopfes. Die Fig. 11 zeigt diese Helmantenne schematisch in der Ansicht eines Längsschnittes, der durch die in z-Richtung laufende Mittel- oder Symmetrieachse S und durch zwei diametral gegenüberliegende Streifenleitungs-Arme 11, 12 der Helmantenne geht. Auf der Außenseite des dielektrischen Materials DI jedes Arms verläuft der äußere Leiterstreifen LO und auf den Innenseiten verlaufen die inneren Leiterstreifen L1. Das Untersuchungsobjekt, also ein menschlicher Kopf, ist schematisch durch die Umrissline K angedeutet. Die scheitelseitigen Enden der HF-Leitungsarme bilden jeweils den Speisepunkt und sind mit der Sende-Empfangseinrichtung S/E nach Art der Fig. 5 gekoppelt.

Bei dem in Fig. 11 gezeigten Dimensionierungsbeispiel ist davon ausgegangen, dass die relative Dielektrizitätskonstante $\varepsilon_R$ des Dielektrikums DI gleich 2,2 ist und dass die Magnetresonanzfrequenz 125 MHz beträgt. Bei diesen Parameterwerten müsste jeder HF-Leitungsarm normalerweise etwa 44 cm lang sein, um die gewünschte elektrische Länge von $\lambda/4$ zu erhalten. Da das $B_1$-Feld möglichst nur im Bereich des Gehirns erzeugt werden soll und andere Bereiche (insbesondere am Hals) möglichst feldfrei sein sollen, ist jeder Arm, unter Berücksichtigung der durchschnittlich Kopfgröße, nur etwa 26 cm lang, wobei diese Verkürzung durch Einfügung einer geeignet bemessenen Reaktanz elektrisch ausgeglichen wird (z.B. durch geeignete Bemessung der Tune-Kapazität $C_T$ in Fig. 5). Da das $B_1$-Feld in unmittelbarer Umgebung der HF-Leitungen sehr inhomogen ist und das Vorhandensein von Gewebe nahe der HF-Leitungen zu einem starken Abfall des Gütefaktors führen würde, sollte der Mindestabstand zwischen Kopf und HF-Leitung etwa 2 cm betragen. Aus diesen Überlegungen und aus der durchschnittlichen Kopfgröße ergibt sich für die Helmantenne an ihrer breitesten Stelle ein horizontaler Innendurchmesser "a" von mindestens etwa 23 cm und für die Gesamthöhe ein Wert von mindestens etwa 17,5 cm.

Es hat sich gezeigt, dass die optimale Form der Helmantenne für den erwähnten Zweck eine glockenähnliche Form ist, bei welcher die HF-Leitungen im unteren Bereich bis auf eine Höhe "c" von etwa 11,5 cm parallel (oder ungefähr parallel) zur Symmetrieachse S verlaufen und dann in elliptischer Kurve konvergieren, gemäß einer Ellipse, deren eine Halbachsenlänge a/2 orthogonal zur Symmetrieachse S etwa 12 cm misst und deren andere Halbachsenlänge b/2 gleich etwa 7 cm ist.

Da das magnetische Wechselfeld der Leitungswelle im wesentlichen transversal zur HF-Leitung ausgerichtet ist und mit zunehmender Entfernung abnimmt, legt man den Ort maximalen Leitungsstroms in den unteren, geradlinigen Bereich der HF-Leitungen, wo der Durchmesser der Helmantenne am größten ist. Zu diesem Zweck werden die HF-Leitungen an den scheitelfernen Enden vorzugsweise mit einem Kurzschluss terminiert. Somit erreicht man, dass das Feld in diesem Bereich maximal ist und auch noch nahe der Symmetrieachse eine große Stärke hat. Auch die $B_1$-Komponente (also die Komponente orthogonal zur z-Richtung) ist in diesem Bereich maximal, weil das Feld dort orthogonal zu S-Achse erzeugt wird. Im oberen Bereich der Helmantenne wird der Leitungsstrom und somit das Magnetfeld und mithin auch die $B_1$-Komponente jeder HF-Leitung zum Scheitel hin schwächer. Andererseits führt die Krümmung aber auch zu einer Überlagerung des Feldes aus verschiedenen Teilen der HF-Leitung. Dies wirkt der erwähnten Abschwächung der $B_1$-Komponente kompensierend entgegen; je nach dem Verlauf der Krümmung kann sich aber eine Unterkompensierung, eine Kompensierung oder eine Überkompensierung ergeben. Durch geeignete Wahl des Krümmungsverlaufs kann eine ziemlich genaue Kompensierung erreicht werden, so dass der $B_1$-Gradient minimal wird. Es hat sich gezeigt, dass die beschriebene elliptische Krümmung ein sehr gutes Ergebnis bringt.

Bei einer mit Kurzschluss terminierten $\lambda/4$-Leitung fällt normalerweise der normierte Leitungsstrom vom Kurzschluss bis zum Speisepunkt gemäß einer Cosinusfunktion von 1 auf 0 ab. Wegen der erwähnten "leitungsverkürzenden" Reaktanz am Speisepunkt, ergibt sich beim hier beschriebenen Beispiel aber ein Abfall von 1 auf etwa 0,7 (cos 45°). Dies führt beim hier beschriebenen Aufbau zu einer gewissen Überkompensierung des erwähnten $B_1$-Abfalls im gekrümmten Bereich der HF-Leitungen. Dem kann man durch zusätzliche Modifizierung des Krümmungsverlaufs entgegen wirken, oder dadurch, dass man die gewünschte Leitungsverkürzung von 44 auf 26 cm durch Verwendung eines Dielektrikums mit höherem $\varepsilon_R$-Wert erreicht. So ergibt ein $\varepsilon_R$-Wert von 10 (z.B. Teflon mit Einlagerung von Keramikpulver) bei der verwendeten Streifenleitung (beidseitige Beschichtung mit Cu) für eine Frequenz von 125 MHz eine $\lambda/4$-Leitungslänge von 23 cm. In diesem Fall entfällt die verkürzende Reaktanz am Speisepunkt, so dass der normierte Strom vom kurzgeschlossenen Ende bis zum Speisepunkt von 1 auf 0 abfällt. Numerische Abschätzungen haben gezeigt, dass dann aber eine gewisse Unterkompensierung hinsichtlich des $B_1$-Abfalls eintritt. Eine genaue Kompensierung wird demnach erzielt werden können, wenn man für $\varepsilon_R$ einen Wert von ungefähr 6 wählt und den "Rest" der Verkürzung durch eine entsprechend dimensionierte Reaktanz am Speisepunkt erreicht.

Die erfindungsgemäße Helmantenne hat auch den Vorteil, dass sie sich gut mit weiteren Antennen kombinieren lässt, z.B. mit einer Labelantenne zur Durchführung von CASL-Experimenten. Bei einer Kombination von mehreren HF-Antennen besteht die Gefahr, dass sie miteinander koppeln, wenn das Magnetfeld einer Antenne die andere durchdringt und umgekehrt. Dies führt zu den bekannten Nachteilen der gegenseitigen Beeinflussung der Magnetfelder, zur wechselseitigen Beeinflussung der Resonanzfrequenz und unter medizinischen Gesichtspunkten zu einer negativen Beeinflussung der SAR-Werte.

Perfusionsmessungen am Gehirn mittels CASL-Experiment laufen, falls eine gesonderte Labelspule benutzt wird, üblicherweise folgendermaßen ab: In der Periode der magnetischen Markierung wird HF-Leistung über die Labelantenne in den Hals des Patienten bzw. der Versuchsperson oder des Versuchstiers eingestrahlt, siehe [7], [21]. Dabei wird gleichzeitig ein statischer Magnetfeldgradient (Labelgradient) geschaltet, der entweder durch die Gradienteneinheit des MR-Tomografen oder durch eine geeignete lokale $B_0$-Gradientenspule (siehe [22]) erzeugt werden kann. Im Hirngewebe wird ein stationärer Zustand erzeugt, bei dem die Magnetisierung in Abhängigkeit vom Blutfluss reduziert ist und der über die Helmantenne gemessen und zur Bildgebung ausgelesen wird. Ein weiteres Experiment wird zur Kontrolle durchgeführt, bei dem die magnetische Markierung des Bluts nicht erfolgt. Die Differenz der Bilder mit und ohne magnetische Markierung ist ein quantitatives Maß für den regionalen Blutfluss.

Um höchste Flexibilität bei CASL-Untersuchungen zu erreichen, besteht eine besondere Ausgestaltung der Erfindung darin, eine erfindungsgemäße, mit Leitungswellen arbeitende Helmantenne mit einer Labelantenne zu kombinieren, die ebenfalls mit Leitungswellen arbeitet. Die Labelantenne kann aus einer oder mehreren HF-Leitungen bestehen, wobei auch hier die oben beschriebenen Prinzipien angewendet werden können, um gezielte Feldverteilungen zur optimalen selektiven Ausleuchtung des interessierenden Volumenbereichs zu erreichen und/oder dem $B_1$-Gradienten des magnetischen Wechselfeldes einen gewollten Verlauf über den intessierenden Volumenbereich zu geben.

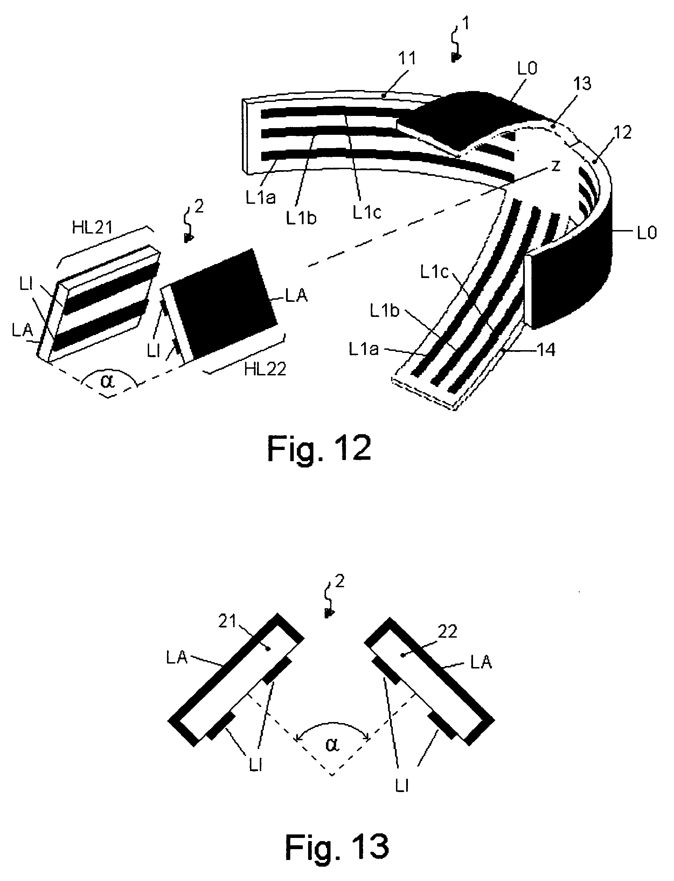

Vorzugsweise werden für die Labelantenne Streifenleitungen verwendet. Eine Kombination einer derartigen Labelantenne mit einer erfindungsgemäßen Helmantenne ist in der Fig. 12 dargestellt.

Die in Fig. 12 gezeigte Helmantenne 1 entspricht dem in Fig. 4 gezeigten Aufbau, d.h., sie weist vier gebogene Arme 11, 12, 13, 14 mit jeweils einer Metallisierung als Grundleiter L0 auf der Außenseite und drei Leiterstreifen L1a, L1b, L1c auf der Innenseite auf. Die körperliche und räumliche Dimensionierung und die Anschluss- und Terminierungsart der Helmantenne 1 können irgendeinem der oben beschriebenen Ausführungsbeispiele entsprechen. Zusätzlich zur Helmantenne 1, die am Kopf eines Patienten anzuordnen wäre, ist eine im Halsbereich des Patienten anzuordnende Labelantenne 2 vorgesehen, bestehend aus zwei HF-Streifenleitungen HL21, HL22, deren Flächennormalen einen Winkel $\alpha$ von ca. 60° bis 180° einschließen können, und die sich in longitudinaler Richtung z erstrecken. Die zwei Streifenleitungen HL21, HL22 verlaufen entlang zweier Trägerplatten 21, 22, die aus einem Material mit einer relativ hohen Dielektrizitätskonstante bestehen (z.B. Teflon mit einer Beimischung von Keramikpulver), um die Wellenlänge längs der Streifenleitungen zu reduzieren. Als Länge für die Streifenleitungen HL21, HL22 wird ein Wert (z.B. ca. 5 cm)gewählt, bei dem die einzelnen Streifenleitungen bequem am Hals über den Schlagadern angebracht werden können.

Um die Streifenleitungen der Labelantenne 2 an ihrem Bestimmungsort zu halten, kann eine Haltevorrichtung wie z.B. ein flexibles Band vorgesehen sein, das um den Hals des Probanden geschlungen werden kann und an dem die Streifenleitungen fest oder verschiebbar angeordnet sind. Die Streifenleitungen der Labelantenne 2 können aber auch fest oder verstellbar am Rahmen des MR-Gerätes angeordnet sein, der auch die Helmantenne 1 hält.

Je nach Stärke des benötigten Magnetfeldes senkrecht zur Blutflussrichtung im Bereich der Halsschlagadern können auf der Innenseite der betreffenden Platte ein oder mehrere Leiterstreifen aufgebracht werden. Die Außenseite jeder Platte ist mit einer Metallisierung versehen, die einen "äußeren" Leiterstreifen LA bildet, der breiter ist als die Anordnung der "inneren" Leiterstreifen LI, die nebeneinander verlaufen, im dargestellten Fall parallel zueinander. Für die Ansteuerung bzw. Terminierung der inneren Leiterstreifen gelten sinngemäß die Ausführungen, die weiter oben zur Helmantenne dargelegt sind. In Fig. 12, Fig. 13 und Fig. 14 ist als Beispiel eine Ausführung mit zwei inneren Leiterstreifen gezeigt.

Die Dicke der dielektrischen Platten 21, 22 ist in einem relativ weiten Bereich wählbar (z.B. 1 bis 5 mm). Als Breite der inneren Leiterstreifen LI ist ein Wert von ca. 0,2 bis 0,5 cm zu empfehlen. Die Streifenbreite und die Materialdicke werden vorteilhaft so gewählt, dass der daraus resultierende Wellenwiderstand etwa dem Wellenwiderstand des (in Fig. 12 nicht gezeigten) Zuleitungskabels entspricht. Die Platten 21, 22 sind auf der Außenseite ganzflächig mit 35 $\mu$m dicker selbstklebender Kupferfolie beklebt (oder mit einem anderen Verfahren metallisiert), um den äußeren Leiterstreifen L1 zu bilden. Die inneren Leiterstreifen LI können ebenfalls durch selbstklebende Cu-Folie der gleichen Dicke gebildet sein. Zur Erhöhung der Fokussierung des $B_1$-Feldes kann man die äußere Metallisierung LA zusätzlich noch auf die longitudinalen Seitenrandflächen der jeweiligen Wand ausdehnen, wie es die Fig. 13 schematisch zeigt.

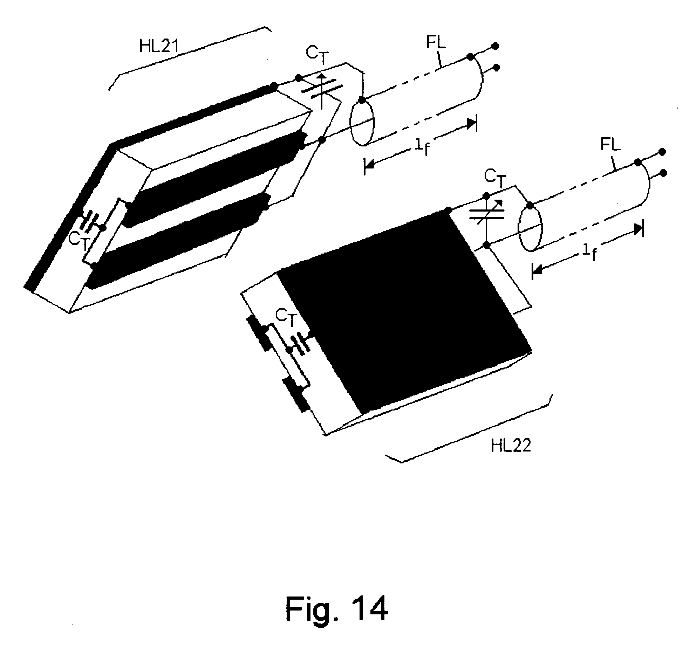

Ein Beispiel für die elektrische Anschlussweise der in Fig. 12 gezeigten Labelantenne 2 ist in Fig. 14 schematisch dargestellt. Jede der Streifenleitungen HL21, HL22 terminiert man an beiden Enden vorzugsweise mit gleich großen Tune-Kondensatoren $C_T$. Diese Kondensatoren werden vorteilhaft so gewählt, dass sich die Anordnung am Speisepunkt, also am Anschlusspunkt für den HF-Sender zur magnetischen Markierung des Blutes, wie ein Parallelschwingkreis verhält. Bei dieser Konfiguration erhält man ein Strommaximum in der Mitte der Streifenleitung, das nach beiden Enden leicht abfällt. Die Zuführung der HF-Leistung zu den Speisepunkten erfolgt jeweils über koaxiale Zuleitungen FL, deren elektrische Länge $l_f$ vorzugsweise ein ungeradzahliges Vielfaches m >= 1 einer Viertelwellenlänge $\lambda/4$ ist:

$$l_f = \lambda/4 * (1 + 2n) , \quad \text{mit } n = 0, 1, 2, ...$$

Wenn das Blut in allen Halsarterien magnetisch markiert werden soll, werden beide Streifenleitungen HL21, HL22 der Labelantenne 2 zueinander parallel geschaltet sind. Für eine höhere Eindringtiefe des Magnetfeldes bei Winkeln zwischen den Flächennormalen beider Streifenleiter größer ca. 120°, erfolgt die Ansteuerung zweckmäßigerweise mit einer 180° Phasendifferenz. Dann addieren sich in der Tiefe die Beiträge beider Streifenleitungen HL21, HL22 zum Magnetfeld. Soll die Markierung nur mittels einer Streifenleitung erfolgen, d.h. nur die Halsschlagader der linken oder rechten Seite magnetisch markiert werden, wird nur die gewünschte Leitung angeschlossen, die andere Leitung bleibt dann am Speisepunkt offen. Wenn die Zuleitungen FL die oben genannte Länge $l_f$ haben, dann führt ein offener Eingang jeweils zum Kurzschluss des Tune-Kondensators $C_T$ am anderen Ende der Leitung und zur Verstimmung der entsprechenden HF-Streifenleitung.

Es sei erwähnt, dass die relative Lage beider Streifenleiter an die anatomischen Gegebenheiten des Probanden bzw. Patienten angepasst werden kann. Dies wird z.B. durch ein flexibles Band erreicht, in das beide Streifenleiter eingearbeitet sind. Dieses Band wird dann am Hals des Probanden bzw. Patienten angebracht. Der Winkel zwischen den Flächennormalen der Streifenleiter kann dabei von 180° (antiparallele Stellung) bis zu ca. 60° variieren. Die Kopplung zwischen beiden Streifenleitungen bleibt in allen Fällen gering.

Im Folgenden werden verschiedene Varianten eines CASL-Verfahrens zur Perfusionsmessung mittels der in Fig. 12 gezeigten Anordnung einer Helmantenne 1 und einer Labelantenne 2 beschrieben. Beide Antennen 1 und 2 sind jeweils über einen eigenen HF-Übertragungskanal unabhängig voneinander mit einem Sender bzw. Empfänger verbunden. Alternativ ist es auch möglich, einen einzigen Kanal zu verwenden und diesen schnell für einen alternierenden Betrieb beider Antennen hin und her zu schalten. Der Kopf des Probanden oder Patienten wird von der Helmantenne 1 umgriffen. Diese wird über das Tune- und Match-Netzwerk auf die $^1$H-Resonanzfrequenz bei der entsprechenden Magnetfeldstärke $B_0$ des Hauptfeldes abgestimmt. Die Labelantenne 2 wird am Hals des Probanden oder Patienten positioniert. Auch diese Antenne wird auf die $^1$H-Resonanzfrequenz abgestimmt.

Bei einer ersten Variante wird nur eine Streifenleitung der Labelantenne 1 abgestimmt, entweder nur die Leitung HL21 oder nur die Leitung HL22, um selektiv nur das Blut in der rechten oder der linken Carotisarterie zu markieren. Die Zuleitung FL der anderen Streifenleitung wird in diesem Fall offen terminiert. Bei der zweiten Variante werden die zwei Streifenleitungen HL21 und HL22 angeschlossen, um das Blut sowohl der linken als auch der rechten Carotis- und Vertebralarterien zu markieren. Die Streifenleitungen HL21, HL22 links und rechts werden dabei mit um 180° phasenverschobener HF-Leistung angesteuert, um die Eindringtiefe des Magnetfeldes zu erhöhen.

Da die Kopplung zwischen einer erfindungsgemäßen Helmantenne 1 und der Labelantenne 2 wegen der vorwiegend transversalen Ausrichtung des Magnetfeldes bei beiden Antennen vernachlässigbar gering ist, bedarf es keinerlei Maßnahmen zur elektronischen Entkopplung der beiden Antennen.

Es sei hier darauf hingewiesen, dass die beschriebene Anordnung ein Höchstmaß an Flexibilität für die Perfusionsmessung erlaubt. So lassen sich die Arterien nur der linken oder rechten Seite bzw. alle Arterien wahlweise magnetisch markieren. Außerdem kann bei Verwendung einer lokalen Gradientenspule die Bildgebung als vollkommen unabhängig vom Vorgang der magnetischen Markierung angesehen werden. Damit ist auch eine magnetische Markierung während der Bildaufnahme, also der gleichzeitige Betrieb beider Antennen, möglich, was die maximal mögliche zeitliche Auflösung der Perfusionsmessung sowie die maximal mögliche Sensitivität erreicht. Diese Gleichzeitigkeit des Betriebs beider Antennen kann mit den bisher verfügbaren elektronisch entkoppelten Systemen nicht erreicht werden.

Es sei erwähnt, dass das beschriebene CASL-Verfahren mit einer erfindungsgemäß ausgebildeten Antennenkombination auch zur Untersuchung der Perfusion an anderen Körperregionen eingesetzt werden kann, wobei die Antennen jeweils an die anatomischen Gegebenheiten der betreffenden Region anzupassen sind. Es ist auch möglich, erfindungsgemäß ausgebildete Antennenkombinationen für CASL-analoge Untersuchungen an anderen Objekten durchzuführen. In allen Fällen kann die Abstimmung auch auf die Magnetresonanz anderer Kernsorten als $^1$H erfolgen.

Bei den in den Figuren dargestellten Ausführungsbeispielen ist die körperliche Struktur der HF-Leitungen in allen Querschnitten über die Leitungslänge konstant, sowohl hinsichtlich der Materialien als auch hinsichtlich der Querschnittsgeometrie. Von dieser "Querschnittskonstanz" kann jedoch abgewichen werden, um die Feldverteilung ortsabhängig entlang der Leitungslänge zusätzlich zu variieren, wie bereits weiter oben erwähnt. So können z.B. die Breite und/oder Dicke der Streifenleitungen über die Leitungslänge variieren. Wenn die Streifenleitung mehrere "innere" Leiterstreifen nebeneinander enthält, kann deren Verlauf auch anders als parallel sein; der gegenseitige Abstand dieser Leiterstreifen kann sich in kontinuierlicher oder gestufter Weise über die Länge ändern. Eine Variation der Querschnittsgeometrie kann auch so gestaltet werden, dass sich ein allmählicher Übergang des Wellenwiderstandes der HF-Leitung an den Wellenwiderstand der Zuleitung ergibt.

Die in der vorstehenden Beschreibung und in den Figuren 3 bis 14 offenbarten Beispiele mögen veranschaulichen, dass und wie es mittels HF-Leitungen als Magnetresonanz-Antennenelementen in neuartiger Weise gelingen kann, gezielte Feldverteilungen zur optimalen selektiven Ausleuchtung eines interessierenden Volumenbereichs zu erreichen. Diese Erkenntnisse können, wie oben erwähnt, sowohl auf die Helmantenne als auch auf eine eventuell vorhandene oder benötigte Labelantenne angewendet werden. Letzteres bringt sogar dann Vorteile, wenn man für die Helmantenne ein herkömmliches Design verwendet oder zur Detektion der von der Labelantenne "markierten" Spins irgendein anderes Antennengebilde benutzt.

Generell können besagte Erkenntnisse auf jede Art von HF-Antennen für Magnetresonanzmessungen angewendet werden, indem man die Kontur einer einzigen oder mehrerer HF-Leitungen in ihrer Längsrichtung zumindest ungefähr an die jeweilige Oberflächenkontur des Untersuchungsobjektes anpasst, welche am Bestimmungsort der Antennenanordnung existiert, und indem man die elektrische Länge, die Terminierung und ausgewählte Merkmale der körperlichen Struktur (z.B. einen oder mehrere der oben angegebenen Parameter) der oder jeder HF-Leitung so wählt oder aufeinander abstimmt, dass sich in der betreffenden HF-Leitung bei der Magnetresonanzfrequenz eine stehende Leitungswelle ergibt, deren magnetisches Wechselfeld entlang der Länge der HF-Leitung ein Intensitätsprofil hat, bei welchem die Kopplung mit den Spins des Untersuchungsobjektes auf den interessierenden Volumenbereich optimal ist, wenn sich die betreffende HF-Leitung an ihrem Bestimmungsort befindet. Dieses "Optimum" mag eine möglichst starke Konzentration bzw. Fokussierung der $B_1$-Feldstärke auf den interessierenden Volumenbereich sein, ein gewollter oder ein möglichst minimaler $B_1$-Gradient (also möglichst maximale $B_1$-Homogenität) in diesem Bereich, oder ein optimaler Kompromiss zwischen diesen Dingen.

**Patentansprüche**

1. HF-Antennensystem zum Anregen und/oder Erfassen der Magnetresonanz in einem zu untersuchenden Objekt, das einem magnetischen Hauptfeld ausgesetzt ist, welches die Spins des Objektes in einer gewünschten Longitudinalrichtung (z) ausrichtet,
mit mindestens einem ersten Antennengebilde (1), enthaltend mehrere Leitungsabschnitte (11, 12, 13, 14), die jeweils zum Leiten hochfrequenten Wechselstroms ausgelegt sind und die sich von einem gemeinsamen Scheitelbereich krallenförmig auseinanderstrebend bis zu einem Basisbereich erstrecken, um einen das interessierende Volumen enthaltenden Teil des Untersuchungsobjektes helmartig zu umgreifen,
**dadurch gekennzeichnet,**
**dass** jeder Leitungsabschnitt (11, 12, 13, 14) als HF-Leitung (HL) ausgebildet ist zum Führen einer sich im TEM-Modus oder in einem Quasi-TEM-Modus ausbreitenden Leitungswelle in elektromagnetischer Kopplung mit Spins des zu umgreifenden Untersuchungsobjektes,
und **dass** die elektrische Länge und die Terminierungen der HF-Leitungen (HL) so gewählt sind, dass sich bei der Frequenz der Magnetresonanz stehende Wellen in den HF-Leitungen ergeben.

2. HF-Antennensystem nach Anspruch 1, **gekennzeichnet durch** ein zweites Antennengebilde (2) zum Anregen der Magnetresonanz in einem zweiten Teil des Untersuchungsobjektes, der ein zweites interessierendes Volumen enthält, mit mindestestens einer HF-Leitung zum Führen einer sich im TEM-Modus oder in einem Quasi-TEM-Modus ausbreitenden Leitungswelle in elektromagnetischer Kopplung mit Spins des zweiten Teils des Untersuchungsobjektes.

3. HF-Antennensystem nach Anspruch 1 oder 2, **gekennzeichnet durch** eine derartige Dimensionierung der elektrischen Länge, der Terminierung und von Parametern der körperlichen Struktur jeder HF-Leitung (HL) zumindest des ersten Antennengebildes (1), dass das magnetische Wechselfeld der stehenden Leitungswelle entlang der Länge der HF-Leitungen bei der Magnetresonanzfrequenz ein Intensitätsprofil hat, bei welchem die Kopplung mit den Spins des Untersuchungsobjektes auf den jeweils interessierenden Volumenbereich fokussiert ist, wenn das betreffende Antennengebilde an seinem Bestimmungsort ist.

4. HF-Antennensystem nach einem der Ansprüche 1 bis 3, **gekennzeichnet durch** eine derartige Dimensionierung der elektrischen Länge, der Terminierung und von Parametern der körperlichen Struktur jeder HF-Leitung (HL) zumindest des ersten Antennengebildes (1), dass der Gradient der in der besagten longitudinalen Richtung (z) gemessenen Komponente des resultierenden magnetischen Wechselfeldes der Leitungswellen über den interessierenden Volumenbereich einen gewünschten Verlauf hat, wenn das erste Antennengebilde an seinem Bestimmungsort ist.

5. HF-Antennensystem nach einem der Ansprüche 1 bis 3, **gekennzeichnet durch** eine derartige Dimensionierung der elektrischen Länge, der Terminierung und von Parametern der körperlichen Struktur jeder HF-Leitung (HL) zumindest des ersten Antennengebildes (1), dass der Gradient der in der besagten longitudinalen Richtung (z) gemessenen Komponente des resultierenden magnetischen Wechselfeldes der Leitungswellen über den interessierenden Volumenbereich minimal ist, wenn das erste Antennengebilde an seinem Bestimmungsort ist.

6. HF-Antennensystem nach einem der vorhergehenden Ansprüche, **dadurch gekennzeichnet, dass** an oder in zumindest einer der HF-Leitungen (HL) mindestens ein reaktives Element ($C_T$) vorgesehen ist, um die gewünschte elektrische Länge der betreffenden HF-Leitung bei einer gewünschten geometrischen Länge zu erreichen.

7. HF-Antennensystem nach einem der vorhergehenden Ansprüche, **gekennzeichnet durch** eine derartige Bemessung der elektrischen Länge und der Terminierung jeder HF-Leitung (HL) des ersten Antennengebildes (1), dass bei der Magnetresonanzfrequenz die Intensität des Wechselstroms auf der HF-Leitung vom Scheitelbereich bis zum Basisbereich kontinuierlich zunimmt.

8. HF-Antennensystem nach einem der vorhergehenden Ansprüche, **dadurch gekennzeichnet, dass** die HF-Leitungen (HL) zumindest des ersten Antennengebildes (1) als Streifenleitungen ausgebildet sind.

9. HF-Antennensystem nach Anspruch 8, **dadurch gekennzeichnet, dass** jede HF-Leitung (HL) zumindest eines der Antenngebilde (1, 2) mindestens zwei Leiterstreifen (L0, L1; LA, LI) mit einem dazwischen angeordneten Dielektrikum (DI) aufweist, wobei einer der Leiterstreifen (L0; LA) als äußerer Leiterstreifen auf einer Seite des Dielektrikums verläuft, die dem zu umgreifenden Objekt abgewandt ist, und der bzw. jeder andere Leiterstreifen (L1; LI) als innerer Leiterstreifen auf der gegenüberliegenden Seite des Dielektrikums verläuft, die dem zu umgreifenden Objekt zugewandt ist.

10. HF-Antennensystem nach Anspruch 9, **dadurch gekennzeichnet, dass** das Dielektrikum (DI) ein dielektrisches Trägermaterial ist, auf dessen Oberflächen die Leiterstreifen (L0, L1) aufgebracht sind.

11. HF-Antennensystem nach Anspruch 9 oder 10, **dadurch gekennzeichnet, dass** der äußere Leiterstreifen (L0; LA) zur Unterdrückung von Wirbelströmen in Längsrichtung geschlitzt ist.

12. HF-Antennensystem nach einem der Ansprüche 9 bis 11, **dadurch gekennzeichnet, dass** die Breite des oder jedes inneren Leiterstreifens (L1; LI) höchstens gleich dem 20-fachen der Dicke des Dielektrikums (DI) ist.

13. HF-Antennensystem nach einem der Ansprüche 9 bis 12, **dadurch** gekenzeichnet, dass die Dicke jedes Leiterstreifens (L0, L1) mindestens gleich der Skintiefe bei der Magnetresonanzfrequenz ist.

14. HF-Antennensystem nach einem der Ansprüch 9 bis 13, **dadurch gekennzeichnet, dass** der äußere Leiterstreifens (L0; LA) die von dem oder den inneren Leiterstreifen (L1; LI) eingenommene Breite beidseitig überragt.

15. HF-Antennensystem nach einem der Ansprüche 9 bis 14, **dadurch gekennzeichnet, dass** an mindestens einer der HF-Leitungen (HF) mindestens zwei innere Leiterstreifen (L1; LI) vorgesehen sind, die an oder nahe einem ersten Ende der HF-Leitung (HL) Koppelanschlüsse (P) zur individuellen Ein- und/oder Auskoppelung von HF-Leistung haben und am zweiten Ende der HF-Leitung jeweils Endanschlüsse (Q) zur individuellen Terminierung gegenüber dem äußeren Leiterstreifen haben.

16. HF-Antennensystem nach einem der Ansprüche 9 bis 14,
    **dadurch gekennzeichnet,**
    **dass** an mindestens einer der HF-Leitungen (HF) mindestens zwei innere Leiterstreifen (L1; LI) vorgesehen sind,
    und **dass** die inneren Leiterstreifen an beiden Enden der HF-Leitung (HL) jeweils miteinander kurzgeschlossen sind und **dass** an oder nahe einem ersten Ende der HF-Leitung (HL) Anschlussmittel zum Ein- und/oder Auskoppeln von HF-Energie an der HF-Leitung über eine gemeinsame Zuleitung vorgesehen sind.

17. HF-Antennensystem nach einem der vorhergehenden Ansprüche, **dadurch gekennzeichnet,**
    **dass** jedes Ende zumindest einer der HF-Leitungen (HL) in gleicher Weise terminiert ist,
     und **dass** eine Umschalteinrichtung (FL1, FL2, SW) vorgesehen ist, um das zweite Ende wahlweise in seiner elektrischen Funktion mit dem ersten Ende zu vertauschen.

18. HF-Antennensystem nach einem der vorhergehenden Ansprüche, **gekennzeichnet durch** einen derartigen räumlichen Verlauf der HF-Leitungen (HL) des ersten Antennengebildes, dass sie zumindest denjenigen Teil des Kopfes eines Probanden helmartig umgreifen können, der das Gehirn enthält.

19. HF-Antennensystem nach Anspruch 18 **dadurch gekennzeichnet, dass** die HF-Leitungen des ersten Antennengebildes (1) an den scheitelfernen Enden kurzgeschlossen terminiert sind und eine elektrische Länge haben, die unter Beladung des Antennengebildes durch das Untersuchungsobjekt im wesentlichen gleich einer Viertelwellenlänge $\lambda/4$ bei der Magnetresonanzfrequenz ist.

20. HF-Antennensystem nach Anspruch 18 oder 19, **dadurch gekennzeichnet, dass** die HF-Leitungen (HL) des ersten Antennengebildes (1) ausgehend vom Scheitelbereich in Richtung zum Basisbereich gekrümmt sind, bis sie im letzten Teil ihrer Länge eine zumindest annähernd parallele Ausrichtung zur Mittelachse erreichen.

21. HF-Antennensystem nach Anspruch 20, **dadurch gekennzeichnet, dass** die Krümmung zumindest annähernd einer Ellipse folgt, wobei eine Halbachse der Ellipse mit der Mittelachse zusammenfällt.

22. HF-Antennensystem nach einem der vorhergehenden Ansprüche, **dadurch gekennzeichnet, dass** das erste Antennengebilde (1) zwei um 90° zueinander winkelversetzte Paare jeweils diametral auseinanderstrebender HF-Leitungen (HL) enthält und **dass** eine Vorrichtung vorgesehen ist zum Ein- und/oder Auskoppeln von HF-Leistung an den HF-Leitungen einer relativen Phasenlage, bei welcher zwischen den HF-Leitungen des jeweils selben Paares ein Phasenunterschied von 180° besteht und zwischen den beiden Paaren ein Phasenunterschied von 90° besteht.

23. HF-Antennensystem nach einem der Ansprüche 18 bis 22, **dadurch gekennzeichnet, dass** das zweite Antennengebilde (2) zur Installation am Hals eines Probanden ausgebildet ist, um das zum Gehirn fließende Blut magnetisch zu markieren.

24. HF-Antennensystem nach Anspruch 23, **dadurch gekennzeichnet**, das das zweite Antennengebilde (2) mindestens zwei HF-Leitungen (HL21, HL22) enthält und eine Haltevorrichtung aufweist, um eine erste HF-Leitung in einer Position zur Magnetresonanz-Anregung des Blutes der linken Carotisarterie zu halten und eine zweite HF-Leitung zur Magnetresonanz-Anregung des Blutes der rechten Carotisarterie zu halten.

25. HF-Antennensystem nach Anspruch 23 oder 24, **gekennzeichnet durch** eine derartige Bemessung der elektrischen Länge und der Terminierung der oder jeder HF-Leitung (HL21, HL22) des zweiten Antennengebildes (2), dass bei der Magnetresonanzfrequenz die Intensität des Wechselstroms auf den HF-Leitungen von beiden Enden her zur Mitte kontinuierlich zunimmt.

# Fig. 1

## Stand der Technik

Fig. 2

Fig. 3

Fig. 4

## Fig. 5

## Fig. 6

## Fig. 7

Fig. 8

Fig. 9

B₁-Feld
[A/m]·10³

Fig. 10

Fig. 11

Fig. 12

Fig. 13

Fig. 14

| | Europäisches Patentamt | EUROPÄISCHER RECHERCHENBERICHT | Nummer der Anmeldung EP 04 01 8597 |
|---|---|---|---|

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | ZHANG X ET AL: "A microstrip transmission line volume coil for human head MR imaging at 4T" JOURNAL OF MAGNETIC RESONANCE, ACADEMIC PRESS, ORLANDO, FL, US, Bd. 161, Nr. 2, April 2003 (2003-04), Seiten 242-251, XP004421027 ISSN: 1090-7807 siehe die Kapitel 2-4 ----- | 1,3-16, 18-22 | G01R33/34 G01R33/345 |
| X | US 2002/079996 A1 (UGURBIL KAMIL ET AL) 27. Juni 2002 (2002-06-27) * Absätze [0010] - [0037]; Abbildungen 2,4,5,7,10,14 * ----- | 1,3-16, 18-22 | |
| D,A | LEE R F ET AL: "Planar strip array (PSA) for MRI" MAGNETIC RESONANCE IN MEDICINE, ACADEMIC PRESS, DULUTH, MN, US, Bd. 45, Nr. 4, April 2001 (2001-04), Seiten 673-683, XP002267960 ISSN: 0740-3194 siehe die Kapitel 'Standing Wave PSA (SW-PSA)', 'Standing and Travelling Waves' and 'Discussion' ----- | 1,3, 6-15,17, 25 | |
| A | WO 03/058283 A (BOTTOMLEY PAUL A ; UNIV JOHNS HOPKINS MED (US)) 17. Juli 2003 (2003-07-17) * Seite 34, Zeile 31 - Seite 36, Zeile 4 * * Seite 38, Zeile 25 - Seite 39, Zeile 28 * * Seite 42, Zeile 7 - Seite 51, Zeile 23; Abbildungen 1,6-9 * ----- -/-- | 1,6, 8-14,18, 19 | |

**RECHERCHIERTE SACHGEBIETE (Int.Cl.7)**

G01R

Der vorliegende Recherchenbericht wurde für alle Patentansprüche erstellt

| Recherchenort | Abschlußdatum der Recherche | Prüfer |
|---|---|---|
| München | 19. Oktober 2004 | Lersch, W |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**Europäisches Patentamt**

## EUROPÄISCHER RECHERCHENBERICHT

Nummer der Anmeldung

EP 04 01 8597

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | EP 0 758 092 A (PICKER INT INC) 12. Februar 1997 (1997-02-12) * Spalte 5, Zeile 16 - Spalte 10, Zeile 37; Abbildungen 2,6,11 * ----- | 1-7, 18-24 | |
| A | K.L.MEYER ET AL.: "A Quadrature 5x5 Mesh Dome Resonator for Head Imaging and Spectroscopy" PROC.SOC.MAG.RESON. 2, 1994, XP002301293 Konferenzbeitrag ----- | 1,3-7, 18-22 | |
| A | DE 101 19 323 A (RAPID BIOMEDICAL BIOMEDIZINISC) 24. Oktober 2002 (2002-10-24) * Absätze [0042] - [0048]; Abbildungen 6b,7,8 * ----- | 1,18, 20-22 | |
| A | T.MILDNER ET AL.: "Functional perfusion imaging using continuous arterial spin labeling with separate labeling and imaging coils at 3 Tesla" PROC.INTL.SOC.MAG.RESON.MED. 10, 2002, XP002301294 Konferenzbeitrag ----- | 2,23,24 | |

RECHERCHIERTE SACHGEBIETE (Int.Cl.7)

Der vorliegende Recherchenbericht wurde für alle Patentansprüche erstellt

| Recherchenort | Abschlußdatum der Recherche | Prüfer |
|---|---|---|
| München | 19. Oktober 2004 | Lersch, W |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

..............................................................................................

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 04 01 8597

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

19-10-2004

| Im Recherchenbericht angeführtes Patentdokument | Datum der Veröffentlichung | Mitglied(er) der Patentfamilie | Datum der Veröffentlichung |
|---|---|---|---|
| US 2002079996 A1 | 27-06-2002 | AU 9673801 A<br>EP 1344076 A1<br>JP 2004511278 T<br>WO 0231522 A1 | 22-04-2002<br>17-09-2003<br>15-04-2004<br>18-04-2002 |
| WO 03058283 A | 17-07-2003 | WO 03058283 A1 | 17-07-2003 |
| EP 0758092 A | 12-02-1997 | US 5602479 A<br>EP 0758092 A1<br>JP 9051886 A | 11-02-1997<br>12-02-1997<br>25-02-1997 |
| DE 10119323 A | 24-10-2002 | DE 10119323 A1 | 24-10-2002 |

EPO FORM P0461

Für nähere Einzelheiten zu diesem Anhang : siehe Amtsblatt des Europäischen Patentamts, Nr.12/82